# EUROPEAN PATENT APPLICATION

(11) **EP 4 836 653 A1**
(43) Date of publication of application: **04.11.2026**
(21) Application number: 26162432.4
(22) Date of filing: 04.03.2026
(51) Int. Cl.: H10K 59/131, H10K 59/40, H10K 77/10

(54) **DISPLAY DEVICE AND ELECTRONIC DEVICE**

(30) Priority: 28.04.2025 KR 20250055308
(71) Applicant: Samsung Display Co., Ltd., Yongin-si, Gyeonggi-do 17113 (KR)
(72) Inventor: KIM, Hyeon Jin, Yongin-si (KR); SEONG, Ju Yeop, Yongin-si (KR); LEE, Gun Ho, Yongin-si (KR)
(74) Representative: Marks & Clerk LLP

(57) **Abstract**

A display device includes a first bending adjacent area between a display area and a bending area of a substrate and including a first wiring area and a second wiring area, a first signal transmission line overlapping the first wiring area and being adjacent to a first edge of the substrate, a second signal transmission line overlapping the second wiring area, the first wiring area including a first contact hole through which interlayer lines of the first signal transmission line are interconnected, the second wiring area including a second contact through which interlayer lines of the second signal transmission line are interconnected, and an insulating layer overlapping the first and second signal transmission lines and the second contact hole in the first bending adjacent area, wherein in the first bending adjacent area, the insulating layer is positioned such that a part of the first edge of the substrate remains exposed.

## Description

### BACKGROUND

### 1. Technical Field

The present disclosure relates to display devices, and more particularly, to display devices and/or electronic devices capable of reducing or preventing damage to a signal transmission line around a bending area.

### 2. Description of the Related Art

An organic light emitting display device includes a display element (e.g., an organic light emitting diode) of which luminance is changed by current.

A head mounted display (HMD) to which an organic light emitting display device is applied is an image display device that is worn on a user's head in the form of glasses or a helmet to form a focus at a close distance in front of the user's eyes. The head mounted display may implement virtual reality (VR) or augmented reality (AR).

The head mounted display magnifies an image displayed on a small display device by using a plurality of lenses, and displays the magnified image. Therefore, the display device applied to the head mounted display needs to provide relatively high-resolution images, for example, images with a resolution of 3000 PPI (Pixels Per Inch) or higher. To this end, an organic light emitting diode on silicon (OLEDoS), which is a relatively high-resolution and relatively small organic light emitting display device, is used as the display device applied to the head mounted display. The OLEDoS is an image display device in which an organic light emitting diode (OLED) is located on a semiconductor wafer substrate on which a complementary metal oxide semiconductor (CMOS) is located.

### SUMMARY

Some example embodiments of the present disclosure provide display devices and/or electronic devices capable of reducing or preventing damage to a signal transmission line around a bending area.

According to an example embodiment of the present disclosure, a display device includes a substrate, a first bending adjacent area between a display area of the substrate and a bending area of the substrate, a first signal transmission line overlapping a first wiring area of the first bending adjacent area and being adjacent to a first edge of the substrate, a second signal transmission line overlapping a second wiring area of the first bending adjacent area, a third signal transmission line overlapping a third wiring area of the first bending adjacent area and being adjacent to a second edge of the substrate, the first wiring area of the first bending adjacent area including a first contact hole, through which first interlayer lines of the first signal transmission line are interconnected, the second wiring area of the first bending adjacent area including a second contact hole, through which second interlayer lines of the second signal transmission line are interconnected, the third wiring area of the first bending adjacent area including a third contact hole, through which third interlayer lines of the third signal transmission line are interconnected, and an insulating layer overlapping the first signal transmission line, the second signal transmission line, the third signal transmission line, and the second contact hole in the first bending adjacent area, wherein in the first bending adjacent area, the insulating layer is positioned such that at least a part of the first edge and at least a part of the second edge of the substrate remain exposed.

According to an example embodiment of the present disclosure, an electronic device includes a display device including a screen, wherein the display device includes a substrate, a first bending adjacent area between a display area of the substrate and a bending area of the substrate, a first signal transmission line overlapping a first wiring area of the first bending adjacent area and being adjacent to a first edge of the substrate, a second signal transmission line overlapping a second wiring area of the first bending adjacent area, a third signal transmission line overlapping a third wiring area of the first bending adjacent area and being adjacent to a second edge of the substrate, the first wiring area of the first bending adjacent area including a first contact hole, through which first interlayer lines of the first signal transmission line are interconnected, the second wiring area of the first bending adjacent area including a second contact hole, through which second interlayer lines of the second signal transmission line are interconnected, the third wiring area of the first bending adjacent area including a third contact hole, through which third interlayer lines of the third signal transmission line are interconnected, and an insulating layer overlapping the first signal transmission line, the second signal transmission line, the third signal transmission line, and the second contact hole in the first bending adjacent area, wherein in the first bending adjacent area, the insulating layer is positioned such that at least a part of the first edge and at least a part of the second edge of the substrate remain exposed.

At least some of the above and other features of the invention are set out in the claims.

According to some example embodiments, an insulating layer may not be formed at a first edge and a second edge of a substrate to which a lot of bending stress is applied, particularly at a portion facing the outermost contact holes (e.g., a first contact hole, a third contact hole, a fourth contact hole, and a sixth contact hole). In other words, an insulating layer may be positioned such that at a first edge and a second edge of a substrate, to which a lot of bending stress is applied, remain exposed. Thus, the propagation of cracks generated in the insulating layer may be reduced or prevented. Accordingly, the damage to the signal transmission line in the bending area and its vicinity (e.g., a first bending adjacent area, a second bending adjacent area) may be reduced or prevented.

The effects of the present disclosure are not limited to the above-described effects and other effects which are not described herein will become apparent to those skilled in the art from the following description.

### BRIEF DESCRIPTION OF THE DRAWINGS

The above and other aspects and features of the present disclosure will become more apparent by describing in detail some example embodiments thereof with reference to the attached drawings, in which:
FIG. 1 is a perspective view of a display device according to some example embodiments of the present disclosure;
FIG. 2 is a cross-sectional view of the display device according to some example embodiments of the present disclosure;
FIG. 3 is a cross-sectional view of a display panel according to some example embodiments of the present disclosure;
FIG. 4 is a cross-sectional view of a display area in the display panel according to some example embodiments of the present disclosure;
FIG. 5 is a cross-sectional view of a touch panel according to some example embodiments of the present disclosure;
FIG. 6 shows a bending area, and a display area and non-display areas in the display panel according to some example embodiments of the present disclosure;
FIG. 7 is a cross-sectional view taken along line A-A' of FIG. 6 in a state where a display panel according to some example embodiments of the present disclosure is bent in the bending area;
FIG. 8 is an enlarged view of area X1 of FIG. 6;
FIG. 9 is an enlarged view of area X2 of FIG. 8;
FIG. 10 is a cross-sectional view of the display device taken along line A1-A1' of FIG. 8;
FIG. 11 is a cross-sectional view of the display device taken along line B1-B1' of FIG. 8;
FIG. 12 is an enlarged view of another embodiment of area X1 of FIG. 6;
FIG. 13 is an enlarged view of another embodiment of area X1 of FIG. 6;
FIG. 14 is an enlarged view of another embodiment of area X1 of FIG. 6;
FIG. 15 is an enlarged view of another embodiment of area X1 of FIG. 6;
FIG. 16 is a cross-sectional view of the display device taken along line A2-A2' of FIG. 15;
FIG. 17 is a cross-sectional view of the display device taken along line B2-B2' of FIG. 15;
FIG. 18 is an enlarged view of another example embodiment of area X1 of FIG. 6;
FIG. 19 is an enlarged view of another example embodiment of area X1 of FIG. 6;
FIG. 20 is an enlarged view of another example embodiment of area X1 of FIG. 6;
FIG. 21 is an enlarged view of another example embodiment of area X1 of FIG. 6;
FIG. 22 is an enlarged view of another example embodiment of area X1 of FIG. 6;
FIG. 23 is a cross-sectional view of the display device taken along line A3-A3' of FIG. 22;
FIG. 24 is a cross-sectional view of the display device taken along line B3-B3' of FIG. 22;
FIG. 25 is a block diagram of an electronic device according to an example embodiment; and
FIGS. 26, 27 and 28 are schematic diagrams illustrating electronic devices according to various example embodiments.

### DETAILED DESCRIPTION

The present disclosure will now be described more fully hereinafter with reference to the accompanying drawings, in which some example embodiments of the inventive concepts are shown. The inventive concepts of the present disclosure may, however, be embodied in different forms and should not be construed as limited to the example embodiments set forth herein. Rather, these example embodiments are provided so that this disclosure will be thorough and complete, and will fully convey the scope of the inventive concepts of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

Although the terms "first", "second", etc. may be used herein to describe various elements, these elements should not be limited by these terms. These terms may be used to distinguish one element from another element. Thus, a first element discussed below may be termed a second element without departing from teachings of one or more example embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

As used herein, expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Features of various example embodiments of the present disclosure may be combined partially or totally. As will be clearly appreciated by those skilled in the art, technically various interactions and operations are possible. Various example embodiments can be practiced individually or in combination.

Hereinafter, some example embodiments will be described with reference to the accompanying drawings.

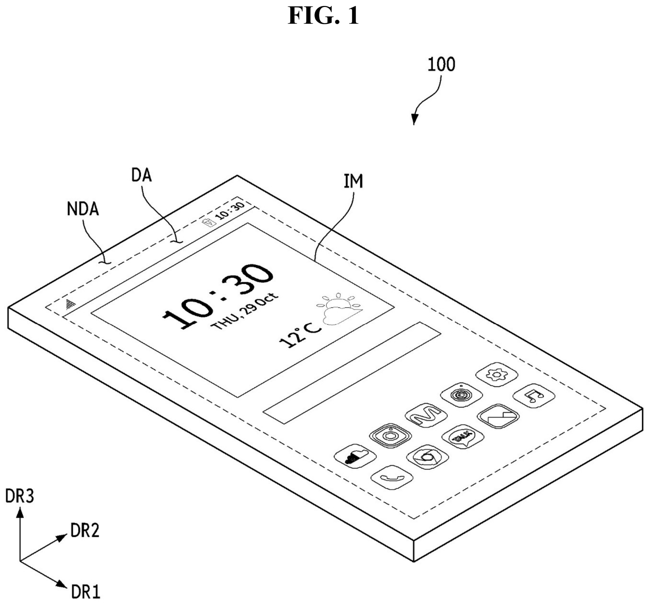

FIG. 1 is a perspective view of a display device according to some example embodiments of the present disclosure.

Referring to FIG. 1, a display device 100 according to an example embodiment of the present disclosure may display an image IM through a display area DA of the front surface. The display area DA may be parallel to a plane defined by a first direction DR1 and a second direction DR2. The thickness direction of the display device 100 may be indicated by a third direction DR3.

The front surface (or top surface) and the rear surface (or bottom surface) of each member or component to be described below may be distinguished by the third direction DR3. However, the first direction DR1, the second direction DR2, and the third direction DR3 illustrated in the present example embodiment are merely an example.

Although a flat display device is illustrated in one example embodiment of the present disclosure, example embodiments of the present disclosure are not limited thereto. For example, the display device 100 according to some example embodiments of the present disclosure may include a curved display device in which at least a part of the display area DA is curved. The display device 100 according to some example embodiments of the present disclosure may include a flexible display device in which at least a part of the display area DA may be folded or bent. The display device 100 according to some example embodiments of the present disclosure may include a stretchable display device in which at least a part of the display area DA is stretched.

The display device 100 according to some example embodiments of the present disclosure, which is a device for displaying a moving image or a still image, may include a portable electronic device such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC). The display device 100 according to some example embodiments of the present disclosure may include an electronic device such as a television, a laptop, a monitor, a billboard, and an Internet-of-Things (IoT) terminal.

Referring to FIG. 1, in the display device 100 according to some example embodiments of the present disclosure, a non-display area NDA may be located around the display area DA. The non-display area NDA, which is an area where the image IM is not displayed, may be a bezel area. A driving circuit (not shown) for driving a plurality of pixels positioned in the display area DA may be located in the non-display area NDA. The non-display area NDA may be located around the display area DA.

Referring to FIG. 1, the display area DA having a right-angled quadrilateral shape is illustrated, but the shape of the display area DA may be different from the right-angled quadrilateral shape. For example, the display area DA may have a quadrilateral shape with rounded corners, a polygonal shape other than a quadrilateral shape, or a circular shape. The shape of the display area DA is not limited thereto, and may be variously changed.

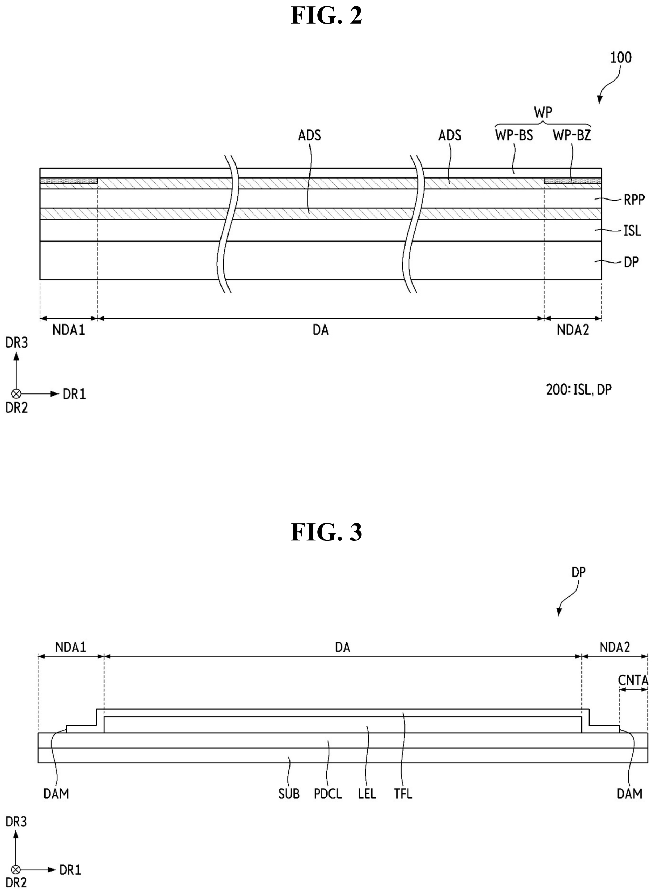

FIG. 2 is a cross-sectional view of the display device 100 according to some example embodiments of the present disclosure.

Referring to FIG. 2, the display device 100 according to some example embodiments of the present disclosure may include a display panel DP, a touch panel ISL, an anti-reflection member RPP, a window WP, or the like. At least some components among the display panel DP, the touch panel ISL, the anti-reflection member RPP, and the window WP may be formed by a continuous process, or at least some components may be bonded to each other by an adhesive member. For example, the display panel DP and the touch panel ISL may be separately formed and attached. For example, at least some components constituting the touch panel ISL may be formed in a process of fabricating the display panel DP.

The adhesive member ADS may be a transparent adhesive member such as a pressure sensitive adhesive film (PSA), an optically clear adhesive (OCA), or an optically clear resin (OCR). The adhesive material to be described below may include a conventional adhesive or tackifier. In the display device 100 according to some example embodiments of the present disclosure, the anti-reflection member RPP and the window WP may be replaced with other components, or may be omitted in some cases.

In the display device 100 according to some example embodiments of the present disclosure, the display panel DP may display an image in the display area DA.

The display panel DP according to some example embodiments of the present disclosure may be a light emitting display panel including a light emitting element.

The light emitting layer of the display panel DP may be an organic light emitting layer including an organic light emitting material. The light emitting layer of the display panel DP may be an inorganic light emitting layer including an inorganic light emitting material. The light emitting layer of the display panel DP may include a light emitting material such as a quantum dot or a quantum rod. In the following, the case where the display panel DP according to some example embodiments of the present disclosure includes an organic light emitting layer will be described as an example, but example embodiments of the present disclosure are not limited thereto.

The touch panel ISL may include one or more touch electrodes. A signal (hereinafter, referred to as touch driving signal) for detecting whether or not a touch input is made and/or for detecting touch coordinates may be inputted to the touch electrode. Depending on the design, the touch driving signal may be of a pulse type or a direct current voltage.

A touch display panel 200 may include the display panel DP and the touch panel ISL.

The anti-reflection member RPP may reduce the reflectivity of external light incident from the upper side of the window WP. The anti-reflection member RPP according to some example embodiments of the present disclosure may include a retarder and a polarizer. The retarder may be of a film type or a liquid crystal coating type. The retarder may include a λ/2 retarder and/or a λ/4 retarder. The polarizer may be of a film type or a liquid crystal coating type. The retarder and the polarizer may further include a protective film. The retarder and the polarizer themselves or the protective film may be defined as a base layer of the anti-reflection member.

The anti-reflection member RPP according to some example embodiments of the present disclosure may include a color filter. The color filter may have a selected arrangement. The arrangement of the color filter may be determined in consideration of the emission colors of pixels included in the display panel DP. The anti-reflection member may further include a black matrix adjacent to the color filter.

The anti-reflection member according to some example embodiments of the present disclosure may include a destructive interference structure. For example, the destructive interference structure may include a first reflective layer and a second reflective layer located on different layers. First reflected light and second reflected light reflected by the first reflective layer and the second reflective layer, respectively, may destructively interfere with each other. Accordingly, the external light reflectivity may be reduced.

The window WP according to some example embodiments of the present disclosure may include a base layer WP-BS and a light blocking pattern WP-BZ. The base layer WP-BS may include a glass substrate and/or a synthetic resin film. The base layer WP-BS is not limited to a single layer.

The base layer WP-BS may include two or more films bonded by an adhesive member.

The light blocking pattern WP-BZ may partially overlap the base layer WP-BS. The light blocking pattern WP-BZ may be located on the rear surface of the base layer WP-BS, and the light blocking pattern WP-BZ may substantially define the non-display area NDA of the display device 100. The area where the light blocking pattern WP-BZ is not located may correspond to the display area DA of the display device 100. For example, the light blocking pattern WP-BZ may be located to overlap a second non-display area NDA2 located in the first direction DR1 which is one side from the display area DA. The light blocking pattern WP-BZ may be located to overlap a first non-display area NDA1 located in the opposite direction of the first direction DR1 which is the other side from the display area DA. The area where the light blocking pattern WP-BZ is located in the window WP may be the light blocking area of the window WP. The area where the light blocking pattern WP-BZ is not located may be the light transmitting area of the window WP.

The light blocking pattern WP-BZ may have a multilayer structure. The multilayer structure may include a chromatic color layer and an achromatic (especially, black) light blocking layer. The chromatic color layer and the achromatic light blocking layer may be formed by a deposition, printing, or coating process. Although not shown separately, the window WP may further include a functional coating layer located on the front surface of the base layer WP-BS. The functional coating layer may include an anti-fingerprint layer, an anti-reflection layer, and/or a hard coating layer.

FIG. 3 is a cross-sectional view of the display panel DP according to some example embodiments of the present disclosure.

Referring to FIG. 3, the display panel DP according to some example embodiments of the present disclosure may include a substrate SUB, a pixel driving circuit layer PDCL, a light emitting element layer LEL, and an upper insulating layer TFL.

The substrate SUB may include at least one synthetic resin film. The substrate SUB may include a glass substrate, a metal substrate, or an organic/inorganic composite material substrate.

The pixel driving circuit layer PDCL may include one or more insulating layers and a circuit element. The circuit element may include a thin film transistor, a capacitor, signal wiring, and the like.

The light emitting element layer LEL may include a light emitting element. Each of a plurality of pixels located in the display area DA may include one or more light emitting elements. The light emitting element layer LEL may include a pixel defining layer PDL that distinguishes each of the plurality of pixels.

The upper insulating layer TFL may be disposed to cover the light emitting element layer LEL. The upper insulating layer TFL may include one or more encapsulation layers. The upper insulating layer TFL may include one or more inorganic encapsulation layers and one or more organic encapsulation layers. The inorganic encapsulation layer (e.g., a first inorganic encapsulation layer) may be located in contact with the light emitting element layer LEL. The organic encapsulation layer may be located on the inorganic encapsulation layer. An inorganic encapsulation layer (e.g., a second inorganic encapsulation layer) may be further located on the organic encapsulation layer. The upper insulating layer TFL may perform a function of protecting the organic light emitting layer of the light emitting element layer LEL from external moisture.

A dam DAM configured to reduce or prevent overflow of the upper insulating layer TFL may be located in the non-display areas NDA1 and NDA2. The dam DAM may be configured to include the pixel defining layer PDL included in the light emitting element layer LEL. The dam DAM may be configured to further include a spacer (not shown) located on the pixel defining layer PDL. The dam DAM may be located in the non-display areas NDA1 and NDA2 to surround the display area DA. A contact part arrangement area CNTA may be located outside the dam DAM.

One or more contact parts may be located in the contact part arrangement area CNTA. The contact part includes a contact hole, and two or more metals forming the pixel driving circuit layer PDCL may be electrically connected in the contact hole. A voltage inputted from the outside of the display panel DP may be transmitted in the opposite direction to the first direction DR1 through the contact part.

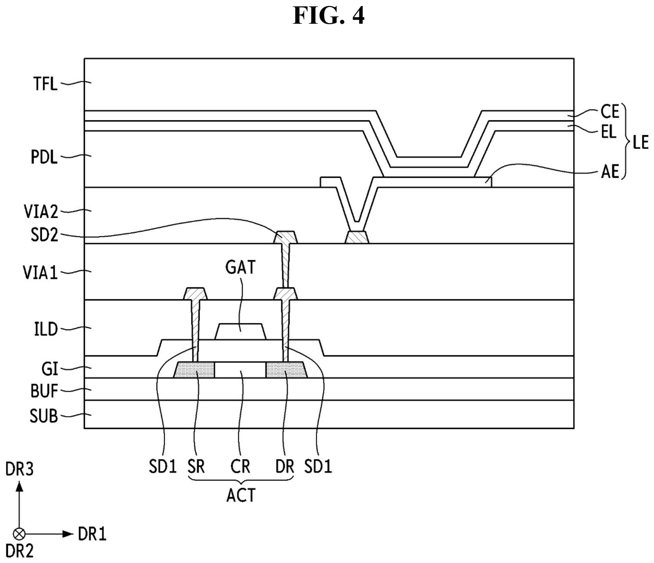

FIG. 4 is a cross-sectional view of a display area in a display panel according to some example embodiments of the present disclosure.

Referring to FIG. 4, the display panel may include the substrate SUB, a buffer layer BUF, a semiconductor layer ACT, a gate insulating layer GI, a gate electrode GAT, an interlayer insulating layer ILD, a first source-drain electrode SD1, a first via layer VIA1, a second source-drain electrode SD2, a first electrode AE, a pixel defining layer PDL, a light emitting layer EL, a second electrode CE, the upper insulating layer TFL, and the like.

The substrate SUB may be formed as a glass substrate, a metal substrate, an organic/inorganic composite material, or the like, as described in FIG. 3. The substrate SUB may be a rigid substrate that is not bent, or may be a flexible substrate that has flexibility.

The buffer layer BUF may be located on the substrate SUB. The buffer layer BUF may perform a moisture permeation prevention/reduction function. Due to the buffer layer BUF, moisture introduced from the outside may be reduced or prevented from permeating into the pixel driving circuit layer. The buffer layer BUF may include one or more inorganic layers. The buffer layer BUF may include two or more layers. The buffer layer BUF may include at least one of metal oxides such as silicon nitride (SiNx), silicon oxide (SiOx), silicon oxynitride (SiOxNy), and aluminium oxide (AlOx). In some cases, the buffer layer BUF may be omitted.

The gate insulating layer GI may be located while covering the semiconductor layer ACT. The gate insulating layer GI may include an inorganic material. The inorganic material may include at least one of silicon nitride (SiNx), silicon oxide (SiOx), silicon oxynitride (SiOxNy), and aluminium oxide (AlOx). According to an example embodiment, the gate insulating layer GI may include an organic material.

The semiconductor layer ACT may constitute a semiconductor of a thin film transistor. The semiconductor layer ACT may include at least one of a polysilicon semiconductor, a single crystal silicon semiconductor, an amorphous silicon semiconductor, and an oxide semiconductor.

The semiconductor layer ACT may include a channel region CR that overlaps a gate electrode GAT to form a channel, a drain region DR located on one side of the channel region CR, and a source region SR located on the other side of the channel region CR. The drain region DR and the source region SR may be semiconductor patterns doped with impurities. The channel region CR may be an intrinsic semiconductor pattern that is not doped with impurities.

The gate electrode GAT may be located on the gate insulating layer GI. The gate electrode GAT may constitute a gate electrode of a thin film transistor.

The interlayer insulating layer ILD may cover the gate electrode GAT. The interlayer insulating layer ILD may be an inorganic layer including an inorganic material. The interlayer insulating layer ILD may include at least one of silicon nitride (SiNx), silicon oxide (SiOx), silicon oxynitride (SiOxNy), and aluminium oxide (AlOx).

The first source-drain electrode SD1 may constitute the source electrode and the drain electrode of the thin film transistor. The first source-drain electrode SD1 may be electrically connected to the source region SR of the semiconductor layer ACT to constitute the source electrode of the thin film transistor. The first source-drain electrode SD1 may be electrically connected to the drain region DR of the semiconductor layer ACT to constitute the drain electrode of the thin film transistor. The first source-drain electrode SD1 may be electrically connected to the semiconductor layer ACT in an area where the interlayer insulating layer ILD and the gate insulating layer GI are removed.

The first via layer VIA1 may cover the first source-drain electrode SD1. The first via layer VIA1 may include an organic layer. The first via layer VIA1 may reduce the stepped portion caused by the first source-drain electrode layer SD1, thereby providing a planarization function.

The second source-drain electrode SD2 may be located on the first via layer VIA1. The second source-drain electrode SD2 may be electrically connected to the first source-drain electrode SD1 in an area where at least a part of the first via layer VIA1 is removed.

The second source-drain electrode SD2 may be made of or include the same material as the material of the first source-drain electrode SD1, but may be made of or include a material different from the material of the first source-drain electrode SD1.

The second via layer VIA2 may be located on the second source-drain electrode SD2. The second via layer VIA2 may include an organic layer. The second via layer VIA2 may reduce the stepped portion caused by the second source-drain electrode SD2, thereby providing a planarization function.

The buffer layer BUF, the semiconductor layer ACT, the gate insulating layer GI, the gate electrode GAT, the interlayer insulating layer ILD, the first source-drain electrode SD1, the first via layer VIA1, the second source-drain electrode SD2, and the second via layer VIA2 may be included in the pixel circuit driving layer PDCL of FIG. 3 described above.

Referring to FIG. 4, the semiconductor layer ACT, the first source-drain electrode SD1, and the gate electrode GAT may constitute the semiconductor, the source electrode, the drain electrode, and the gate electrode of the thin film transistor, respectively. In some cases, the second source-drain electrode SD2 may constitute the source electrode and/or the drain electrode of the thin film transistor.

The first electrode AE may constitute the first electrode of the light emitting element LE. The first electrode AE may be any one of the anode electrode or the cathode electrode of the light emitting element LE. The following description assumes that the first electrode AE is the anode electrode of the light emitting element LE, but example embodiments of the present disclosure are not limited thereto. The first electrode AE may be electrically connected to the thin film transistor. For example, the first electrode AE may be electrically connected to the second source-drain electrode SD2 in an area where the second via layer VIA2 is removed.

The light emitting layer EL may include a light emitting material. For example, the light emitting layer EL may include an organic light emitting material and, in this case, the light emitting layer EL may be an organic light emitting layer. The light emitting layer EL may further include a hole injecting layer, a hole transporting layer, an electron transporting layer, an electron injecting layer, and the like, in addition to the light emitting layer that actually emits light.

The second electrode CE may constitute the second electrode of the light emitting element LE. The second electrode CE may be the other one of the anode electrode or the cathode electrode of the light emitting element LE. The following description assumes that the second electrode CE is the cathode electrode of the light emitting element LE, but example embodiments of the present disclosure are not limited thereto.

An emission area may be defined by the pixel defining layer PDL. The light emitting element LE may emit light in an area (e.g., in an opening) where the pixel defining layer PDL is removed.

The upper insulating layer TFL may be located on the second electrode CE. The upper insulating layer TFL may have a single-layer structure or a multi-layer structure. For example, the upper insulating layer TFL may include two inorganic encapsulation layers, and an organic encapsulation layer located between the two inorganic encapsulation layers.

The organic encapsulation layer may include an organic layer, and may provide a planarizing function. The organic layer may include acrylic resin, epoxy resin, polyimide, polyethylene, or silicon oxycarbon (SiOC). The organic encapsulation layer may include an organic insulating material. The organic encapsulation layer may be formed by an inkjet method.

The inorganic encapsulation layer may include an inorganic insulating material that may be deposited at a low temperature. The inorganic encapsulation layer may be, for example, silicon nitride (SiNx), silicon oxide (SiOx), silicon oxynitride (SiON), or aluminium oxide (Al₂O₃). The inorganic encapsulation layer deposited at a low temperature may reduce or prevent the light emitting layer EL from being damaged by a relatively high temperature.

In FIG. 4, a top emission type in which light is emitted toward the front side (e.g., in the third direction DR3) is illustrated. However, depending on example embodiments, a bottom emission type in which light is emitted toward the rear side (e.g., in the opposite direction to the third direction DR3) may be adopted.

In the case where the top emission type is adopted, an opening formed by removing at least a part of the pixel defining layer PDL may be located to overlap the gate electrode GAT, the first source-drain electrode SD1, and the second source-drain electrode SD2.

In the case where the bottom emission type is adopted, light may sequentially pass through the second via layer VIA2, the first via layer VIA1, the interlayer insulating layer ILD, the gate insulating layer GI, the buffer layer BUF, the substrate SUB, and the like, and then may be emitted to the outside of the display panel. In the case where the bottom emission type is adopted, the opening formed by removing at least a part of the pixel defining layer PDL may be located not to overlap a metal layer having a relatively high reflectivity, such as the gate electrode GAT, the first source-drain electrode SD1, and the second source-drain electrode SD2.

In the case where the bottom emission type is adopted, in some example embodiments, unlike the case illustrated in FIG. 4, the substrate SUB may be positioned in the third direction DR3 from the upper insulating layer TFL. The touch panel ISL (see FIG. 2) may be located on the substrate SUB. The distance between the touch panel ISL (see FIG. 2) and the substrate SUB may be less than the distance between the touch panel ISL (see FIG. 2) and the upper insulating layer TFL.

For simplicity of description, the description has been made on the assumption that the example embodiments of the present disclosure are of a top emission type, but the present disclosure may also be applied to a bottom emission type.

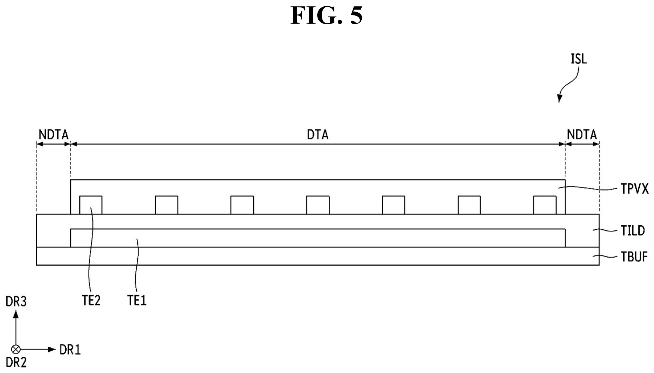

FIG. 5 is a cross-sectional view of the touch panel ISL according to some example embodiments of the present disclosure.

Referring to FIG. 5, the touch panel ISL may include a touch buffer layer TBUF, a first touch electrode TE1, a touch insulating layer TILD, a second touch electrode TE2, a passivation layer TPVX, and the like.

The touch panel ISL may further include a base layer (not shown) corresponding to the substrate. In this case, the touch buffer layer TBUF may further include a base layer. In some cases, the base layer of the touch panel ISL may be omitted. In this case, the touch buffer layer TBUF may be located on the upper insulating layer TFL (see FIG. 4) described above. In the following, for simplicity of description, the case where the touch panel ISL does not further include a base layer will be described, but example embodiments of the present disclosure are not limited thereto.

The touch buffer layer TBUF may be made of or include an organic insulating material having a relatively low dielectric constant. The touch buffer layer TBUF may be made of or include an acryl-based or a siloxane-based material. The touch buffer layer TBUF may reduce or prevent liquid chemical (etching solution, or the like) used in a process of forming the first touch electrode TE1 from flowing into the display panel DP (see FIG. 3), and may reduce or prevent external moisture from permeating into the display panel DP (see FIG. 3). Accordingly, the liquid chemical or moisture may be reduced or prevented from flowing into the light emitting layer EL (see FIG. 4) of the display panel DP (see FIG. 3).

The touch insulating layer TILD may be located on the first touch electrode TE1. The touch insulating layer TILD may electrically insulate the first touch electrode TE1 and the second touch electrode TE2 located in different layers from each other. The touch insulating layer TILD may include one or more inorganic layers. For example, the touch insulating layer TILD may include a first inorganic layer and a second inorganic layer made of different materials from each other. The touch insulating layer TILD may include an inorganic material. The touch insulating layer TILD may include at least one of constituent materials of the interlayer insulating layer ILD and the gate insulating layer GI, for example, silicon nitride (SiNx), silicon oxide (SiOx), silicon oxynitride (SiOxNy), or aluminium oxide (AlOx). According to an example embodiment, the touch insulating layer TILD may include an organic material.

The first touch electrode TE1 and the second touch electrode TE2 may be electrodes to which a touch driving signal is inputted, or may be electrodes in which a touch sensing signal is sensed. A detection area DTA may be defined by an area where the first touch electrode TE1 and the second touch electrode TE2 are located. An area where the first touch electrode TE1 and the second touch electrode TE2 are not located in the touch panel ISL may be defined as a non-detection area NDTA. The touch buffer layer TBUF and/or the touch insulating layer TILD may be located in at least a part of the non-detection area NDTA.

Referring to FIG. 5, it is illustrated that the first touch electrode TE1 and the second touch electrode TE2 are not connected to each other. The first touch electrode TE1 may be a touch driving electrode to which a touch driving signal is applied. The second touch electrode TE2 may be a touch sensing electrode (or a bridge electrode of the touch sensing electrode) in which the amount of change in capacitance due to a touch input is sensed. On the contrary, the first touch electrode TE1 may be a touch sensing electrode, and the second touch electrode TE2 may be a touch driving electrode. A touch sensing method in which a touch driving electrode and a touch sensing electrode are separately provided and a touch input is sensed is referred to as a mutual capacitance sensing method.

In some cases, one touch electrode may perform the functions of both the touch driving electrode and the touch sensing electrode. For example, a touch driving signal may be inputted to the first touch electrode TE1, and the amount of change in capacitance due to the touch input from the first touch electrode TE1 may be sensed (from the first touch electrode TE1). A touch sensing method in which one touch electrode performs the functions of both the touch driving electrode and the touch sensing electrode is referred to as a self-capacitance sensing method.

Some example embodiments of the present disclosure may be applied to both the mutual capacitance type touch sensing method and the self-capacitance type touch sensing method.

Referring to FIG. 5, at least a part of the detection area DTA may overlap the display area DA (see FIG. 3) described above. At least a part of the non-detection area NDTA may overlap the non-display areas NDA1 and NDA2 (see FIG. 3) described above.

Accordingly, at least a part of the touch insulating layer TILD may be located to overlap the first non-display area NDA1. At least a part of the touch insulating layer TILD may be located to overlap the second non-display area NDA2.

The passivation layer TPVX may be located on the second touch electrode TE2. The passivation layer TPVX may perform a function of protecting the first touch electrode TE1 and the second touch electrode TE2. The passivation layer TPVX may include an organic insulating layer. The passivation layer TPVX may include the same material as the material constituting the first via layer VIA1 and/or the second via layer VIA2 described above. The passivation layer TPVX may include thermosetting resin.

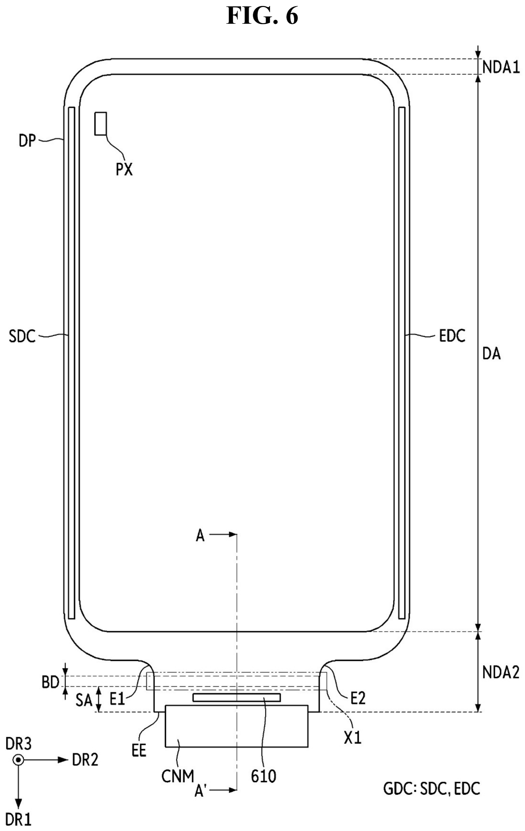

FIG. 6 shows the bending area BD, and the display area DA and the non-display areas NDA1 and NDA2 in the display panel DP according to some example embodiments of the present disclosure.

Referring to FIG. 6, the first non-display area NDA1 may be located in the opposite direction to the first direction DR1 from the display area DA, and the second non-display area NDA2 may be located in the first direction DR1 from the display area DA.

A pad portion for receiving various signals and voltages from components other than the display panel DP may be located in the second non-display area NDA2. For example, a first pad portion (not shown) where an integrated circuit 610 is located and a second pad portion (not shown) electrically connected to a connection member CNM may be located in the second non-display area NDA2. The first pad portion and the second pad portion may be located in a pad portion arrangement area SA.

The first pad portion may include a connector. The first pad portion may include a flexible flat cable (FFC), a flexible printed circuit (FPC), or the like. The second pad portion may include a connector, a flexible flat cable, a flexible printed circuit, or the like, similarly to the first pad portion.

The integrated circuit 610 may include a data driving circuit that may supply a data voltage for displaying an image to the plurality of pixels PX located in the display area DA. The integrated circuit 610 may include a touch driving circuit that supplies a touch driving signal to the touch electrode (e.g., the first touch electrode TE1 (see FIG. 5)) located to overlap the display area DA and receives a touch sensing signal from the touch electrode (e.g., the second touch electrode TE2 (see FIG. 5)). The integrated circuit 610 may include a source driver integrated circuit (SDIC), a read-out integrated circuit (ROIC), a source driver and touch readout integrated circuit (SRIC), and/or the like. The integrated circuit 610 may perform a function of calculating whether or not a touch input is made based on the capacitance change amount of the sensed touch electrode.

The connection member CNM may be configured to transmit various powers inputted from the outside to the integrated circuit 610 or to the display panel DP. The connection member CNM may include a flexible printed circuit board (FPCB) or a rigid printed circuit board (PCB). The connection member CNM may include a flexible flat cable (FFC), a flexible printed circuit (FPC), or the like.

Various voltages may be inputted to the display panel DP through the integrated circuit 610, the connection member CNM, and the like. The voltages inputted to the display panel DP may also be inputted to the plurality of pixels PX located in the display area DA. In some example embodiments, the signals and voltages inputted to the display panel DP may be inputted to a gate driving circuit GDC located in the second direction DR2 of the display area DA and the opposite direction to the second direction DR2. The gate driving circuit GDC may include a scan driving circuit SDC and an emission driving circuit EDC. The scan driving circuit SDC may be located in the first non-display area NDA1 on one side of the display area DA, and the emission driving circuit EDC may be located in the first non-display area NDA1 on the other side of the display area DA. The scan driving circuit SDC and the emission driving circuit EDC may be located in the first non-display area NDA1 to face each other in the second direction DR2.

The scan driving circuit SDC and the emission driving circuit EDC may refer to driving circuits that output a turn-on logic level signal or a turn-off logic level signal to control the emission timing of the plurality of pixels PX located in the display area DA. The scan driving circuit SDC and the emission driving circuit EDC may be directly formed on the display panel DP, or may be mounted as an integrated circuit on the display panel DP. Both the scan driving circuit SDC and the emission driving circuit EDC may be positioned in the same direction (e.g., in the second direction DR2) from the display area DA. Any one of the scan driving circuit SDC or the emission driving circuit EDC may be omitted.

Referring to FIG. 6, in order to reduce or minimize the non-display areas NDA1 and NDA2 shown on the front surface of the display panel DP, at least a part of the second non-display area NDA2 may be bent toward the rear side of the display panel DP. The second non-display area NDA2 may include the bending area BD where the display panel DP is bent. The bending area BD may be located between the display area DA and the pad portion arrangement area SA.

In order to transmit the voltages inputted to the display panel DP toward the display area DA or the driving circuit around the display area DA, a plurality of wires (not shown) crossing the bending area BD may be provided. Referring to FIG. 6, various wires described above may be located in area X1, and the wires crossing the bending area BD may be electrically connected to another metal layer in a contact hole located around the bending area BD.

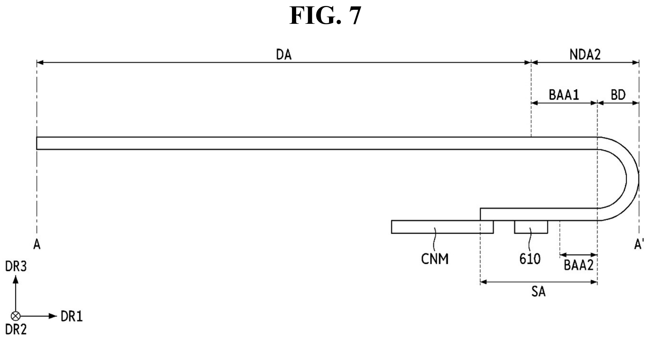

FIG. 7 is a cross-sectional view taken along line A-A' of FIG. 6 in a state where a display panel according to some example embodiments of the present disclosure is bent in the bending area BD.

A contact hole for electrically connecting a wire crossing the bending area BD to another metal layer may be located around the bending area BD. The contact hole may be located between the bending area BD and the display area DA and between the bending area BD and the integrated circuit 610.

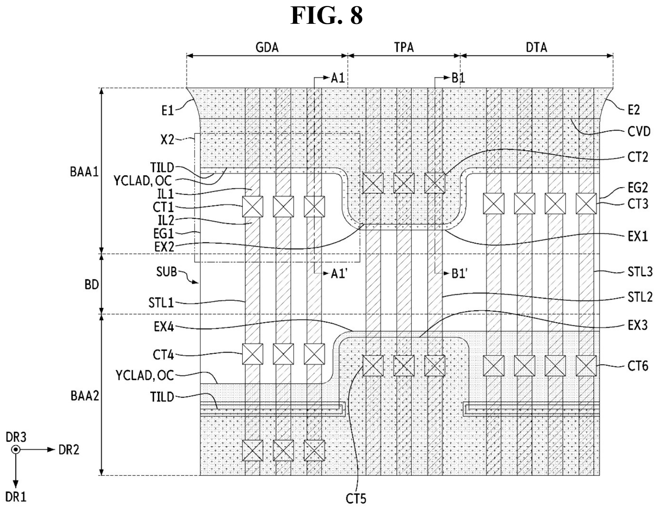

As illustrated in FIG. 6, both connection edges E1 and E2 of the substrate (e.g., substrate SUB of FIGS. 8, 10, and 11) of the display panel (e.g., the display panel DP) on the upper side of the bending area BD may each have a rounded shape. The first connection edge E1 may be connected to a first edge EG1 of the substrate SUB in a first bending adjacent area BAA1 to be described later, and the second connection edge E2 may be connected to a second edge EG2 of the substrate SUB in the first bending adjacent area BAA1 to be described later.

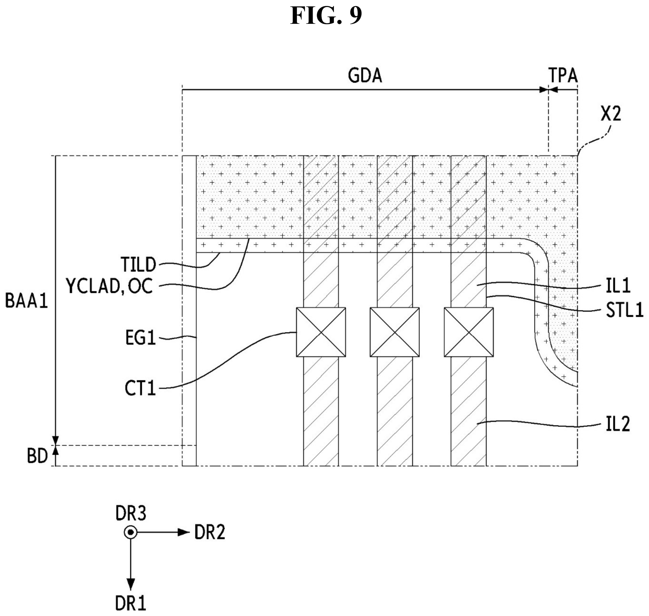

FIG. 8 is an enlarged view of area X1 of FIG. 6, and FIG. 9 is an enlarged view of area X2 of FIG. 8.

Referring to FIG. 8, the second non-display area NDA2 may include the bending area BD, the first bending adjacent area BAA1, and a second bending adjacent area BAA2. The first bending adjacent area BAA1, the bending area BD, and the second bending adjacent area BAA2 may be sequentially located along a direction (e.g., the first direction DR1) directed from the display area DA toward the connection member CNM.

The first bending adjacent area BAA1 and the second bending adjacent area BAA2 may be located adjacent to the bending area BD. For example, the bending area BD may be located between the first bending adjacent area BAA1 and the second bending adjacent area BAA2.

The first bending adjacent area BAA1 may be located on the upper side of the bending area BD, and the second bending adjacent area BAA2 may be located on the lower side of the bending area BD. For example, the first bending adjacent area BAA1 may be located between the bending area BD and the display area DA, and the second bending adjacent area BAA2 may be located between the bending area BD and one edge EE (or the connection member CNM) of the display panel DP. Here, one edge EE of the display panel DP may be one side of the display panel DP that overlaps the connection member CNM.

In the first bending adjacent area BAA1, a first wiring area GDA, a second wiring area TPA, and a third wiring area DTA may be located along the second direction DR2. Here, the first wiring area GDA may be located adjacent to the first edge EG1 of the substrate SUB (or the display panel DP), the third wiring area DTA may be located adjacent to the second edge EG2 of the substrate SUB (or the display panel DP), and the second wiring area TPA may be located between the first wiring area GDA and the third wiring area DTA. Here, the first edge EG1 of the substrate SUB (or the display panel DP) may be one edge of the substrate SUB (or the display panel DP) adjacent to the bending area BD, and the second edge EG2 of the substrate SUB (or the display panel DP) may be the other edge of the substrate SUB (or the display panel DP) adjacent to the bending area BD.

A plurality of first signal transmission lines STL1 and a plurality of first contact holes CT1 may be located in the first wiring area GDA of the first bending adjacent area BAA1. One first signal transmission line STL1 may include a plurality of first interlayer lines located in different layers in the third direction DR3, and the first interlayer lines may be located in different layers in the third direction DR3 while an insulating layer is interposed between the first interlayer lines. The first interlayer lines may be connected to each other through the first contact hole CT1 penetrating the insulating layer. The first signal transmission lines STL1 may be connected to the gate driving circuit GDC (e.g., the scan driving circuit SDC and the emission driving circuit EDC) and the integrated circuit 610. The first signal transmission lines STL1 may transmit first signals from the integrated circuit 610 to the gate driving circuit GDC. The first signals, which are signals desired for driving the gate driving circuit GDC, may include, for example, a gate clock signal and a gate output control signal.

A plurality of second signal transmission lines STL2 and a plurality of second contact holes CT2 may be located in the second wiring area TPA of the first bending adjacent area BAA1. One second signal transmission line STL2 may include a plurality of second interlayer lines located in different layers in the third direction DR3, and the second interlayer lines may be located in different layers in the third direction DR3 while an insulating layer is interposed between the second interlayer lines. The second interlayer lines may be connected to each other through the second contact hole CT2 penetrating the insulating layer. The second signal transmission lines STL2 may be connected to the touch panel ISL, the pixels PX, and the integrated circuit 610. The second signal transmission lines STL2 may transmit second signals from the integrated circuit 610 to the touch panel and the pixels PX. The second signals, which are signals desired for driving the touch panel ISL and the pixels PX, may include, for example, a touch driving signal and a power signal. Here, the touch driving signal may be applied to at least one of the first touch electrode TE1 and the second touch electrode TE2 of the touch panel ISL, and the power signal may be applied to the second electrode CE of each pixel PX.

A plurality of third signal transmission lines STL3 and a plurality of third contact holes CT3 may be located in the third wiring area DTA of the first bending adjacent area BAA1. One third signal transmission line STL3 may include a plurality of third interlayer lines located in different layers in the third direction DR3, and the third interlayer lines may be located in different layers in the third direction DR3 while an insulating layer is interposed between the third interlayer lines. The third interlayer lines may be connected to each other through the third contact hole CT3 penetrating the insulating layer. The third signal transmission lines STL3 may be connected to the pixels PX and the integrated circuit 610. The third signal transmission lines STL3 may transmit third signals from the integrated circuit 610 to the pixels PX. The third signals, which are signals desired for driving the pixels PX, may be, for example, data signals. The third signals from the integrated circuit 610 may be supplied to the pixels PX through the third signal transmission lines STL3 and data lines.

In the first wiring area GDA of the second bending adjacent area BAA2, the plurality of first signal transmission lines STL1 described above and a plurality of fourth contact holes CT4 may be located. One first signal transmission line STL1 may include a plurality of first interlayer lines located in different layers in the third direction DR3, and the first interlayer lines may be located in different layers in the third direction DR3 while an insulating layer is interposed between the first interlayer lines. The first interlayer lines may be connected to each other through the fourth contact hole CT4 penetrating the insulating layer.

In the second wiring area TPA of the second bending adjacent area BAA2, the plurality of second signal transmission lines STL2 described above and a plurality of fifth contact holes CT5 may be located. One second signal transmission line STL2 may include a plurality of second interlayer lines located in different layers in the third direction DR3, and the second interlayer lines may be located in different layers in the third direction DR3 while an insulating layer is interposed between the second interlayer lines. The second interlayer lines may be connected to each other through the fifth contact hole CT5 penetrating the insulating layer.

In the third wiring area DTA of the second bending adjacent area BAA2, the plurality of third signal transmission lines STL3 described above and a plurality of sixth contact holes CT6 may be located. One third signal transmission line STL3 may include a plurality of third interlayer lines located in different layers in the third direction DR3, and the third interlayer lines may be located in different layers in the third direction DR3 while an insulating layer is interposed between the third interlayer lines. The third interlayer lines may be connected to each other through the sixth contact hole CT6 penetrating the insulating layer.

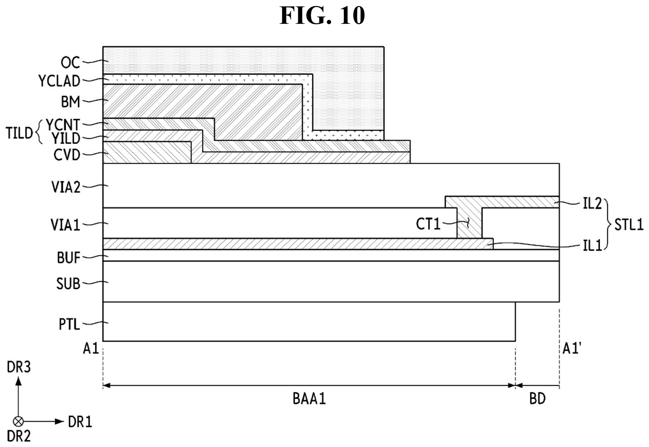

In the first bending adjacent area BAA1, the touch insulating layer TILD (e.g., a first inorganic layer YILD and a second inorganic layer YCNT of FIG. 10) may be located. The touch insulating layer TILD of the first bending adjacent area BAA1 may include a first extension portion EX1 extending along a direction (e.g., the first direction DR1) toward the bending area BD in the first bending adjacent area BAA1. The first extension portion EX1 may be located between the first contact hole CT1 and the third contact hole CT3 adjacent to each other. In the first bending adjacent area BAA1, the touch insulating layer TILD may overlap the first signal transmission lines STL1, the second signal transmission lines STL2, the third signal transmission lines STL3, and the second contact holes CT2. Here, the first extension portion EX1 of the touch insulating layer TILD may overlap the second contact holes CT2. In the first bending adjacent area BAA1, the touch insulating layer TILD may not overlap the first contact holes CT1 and the third contact holes CT3. In other words, in the first bending adjacent area BAA1, the touch insulating layer TILD may be positioned such that the first contact holes CT1 and the third contact holes CT3 remain exposed.

A third inorganic layer YCLAD may be located in the first bending adjacent area BAA1. In the first bending adjacent area BAA1, the third inorganic layer YCLAD and the touch insulating layer TILD may overlap. In this case, in plan view, the edge of the touch insulating layer TILD of the first bending adjacent area BAA1 may be located between the bending area BD and the edge of the third inorganic layer YCLAD of the first bending adjacent area BAA1. The third inorganic layer YCLAD of the first bending adjacent area BAA1 may include a second extension portion EX2 extending along a direction (e.g., the first direction DR1) toward the bending area BD in the first bending adjacent area BAA1. The second extension portion EX2 may be located between the first contact hole CT1 and the third contact hole CT3 that are adjacent to each other. In the first bending adjacent area BAA1, the third inorganic layer YCLAD may overlap the first signal transmission lines STL1, the second signal transmission lines STL2, the third signal transmission lines STL3, and the second contact holes CT2. Here, the second extension portion EX2 of the third inorganic layer YCLAD may overlap the second contact holes CT2. In the first bending adjacent area BAA1, the third inorganic layer YCLAD may not overlap the first contact holes CT1 and the third contact holes CT3. In other words, in the first bending adjacent area BAA1, the third inorganic layer YCLAD may be positioned such that the first contact holes CT1 and the third contact holes CT3 remain exposed.

An overcoat layer OC may be located in the first bending adjacent area BAA1. In the first bending adjacent area BAA1, the overcoat layer OC, the third inorganic layer YCLAD, and the touch insulating layer TILD may overlap. In this case, in plan view, the edge of the overcoat layer OC of the first bending adjacent area BAA1 may overlap (or coincide with) the edge of the third inorganic layer YCLAD of the first bending adjacent area BAA1. The overcoat layer OC of the first bending adjacent area BAA1 may include the second extension portion EX2 extending along a direction (e.g., the first direction DR1) toward the bending area BD in the first bending adjacent area BAA1. The second extension portion EX2 may be located between the first contact hole CT1 and the third contact hole CT3 that are adjacent to each other. In the first bending adjacent area BAA1, the overcoat layer OC may overlap the first signal transmission lines STL1, the second signal transmission lines STL2, the third signal transmission lines STL3, and the second contact holes CT2. Here, the second extension portion EX2 of the overcoat layer OC may overlap the second contact holes CT2. In the first bending adjacent area BAA1, the overcoat layer OC may not overlap the first contact holes CT1 and the third contact holes CT3. In other words, in the first bending adjacent area BAA1, the overcoat layer OC may be positioned such that the first contact holes CT1 and the third contact holes CT3 remain exposed.

The touch insulating layer TILD (e.g., the first inorganic layer YILD and the second inorganic layer YCNT) may be located in the second bending adjacent area BAA2. The touch insulating layer TILD of the second bending adjacent area BAA2 may include a third extension portion EX3 extending along the direction (e.g., the reverse direction of the first direction DR1 (hereinafter, referred to as a first reverse direction)) toward the bending area BD in the second bending adjacent area BAA2. The third extension portion EX3 may be located between the fourth contact hole CT4 and the sixth contact hole CT6 that are adjacent to each other. In the second bending adjacent area BAA2, the touch insulating layer TILD may overlap the first signal transmission lines STL1, the second signal transmission lines STL2, the third signal transmission lines STL3, and the fifth contact holes CT5. Here, the third extension portion EX3 of the touch insulating layer TILD may overlap the fifth contact holes CT5. In the second bending adjacent area BAA2, the touch insulating layer TILD may not overlap the fourth contact holes CT4 and the sixth contact holes CT6. In other words, in the second bending adjacent area BAA2, the touch insulating layer TILD may be positioned such that the fourth contact holes CT4 and the sixth contact holes CT6 remain exposed.

The third inorganic layer YCLAD may be located in the second bending adjacent area BAA2. In the second bending adjacent area BAA2, the third inorganic layer YCLAD and the touch insulating layer TILD may overlap. In this case, in plan view, the edge of the third inorganic layer YCLAD of the second bending adjacent area BAA2 may be located between the bending area BD and the edge of the touch insulating layer TILD of the second bending adjacent area BAA2. The third inorganic layer YCLAD of the second bending adjacent area BAA2 may include a fourth extension portion EX4 extending along a direction (e.g., the first reverse direction) toward the bending area BD in the second bending adjacent area BAA2. In the second bending adjacent area BAA2, the third inorganic layer YCLAD may overlap the first signal transmission lines STL1, the second signal transmission lines STL2, the third signal transmission lines STL3, the fifth contact holes CT5, and the sixth contact holes CT6. Here, the fourth extension portion EX4 of the third inorganic layer YCLAD may overlap the fifth contact holes CT5 and the sixth contact holes CT6. In the second bending adjacent area BAA2, the third inorganic layer YCLAD may not overlap the fourth contact holes CT4. In other words, in the second bending adjacent area BAA2, the third inorganic layer YCLAD may be positioned such that the fourth contact holes CT4 remain exposed.

In the first bending adjacent area BAA1, at least a part of the first edge EG1 and at least a part of the second edge EG2 of the substrate SUB may not overlap the touch insulating layer TILD (e.g., the first inorganic layer YILD and the second inorganic layer YCNT). In other words, in the first bending adjacent area BAA1, the touch insulating layer TILD may be positioned such that at least a part of the first edge EG1 and at least a part of the second edge EG2 of the substrate SUB remain exposed. For example, a portion of the first edge EG1 of the substrate SUB that is adjacent to the first contact hole CT1 may not overlap the touch insulating layer TILD, and a portion of the second edge EG2 of the substrate SUB that is adjacent to the third contact hole CT3 may not overlap the touch insulating layer TILD. In other words, a portion of the first edge EG1 of the substrate SUB that faces the first contact hole CT1 may not overlap the touch insulating layer TILD, and a portion of the second edge EG2 of the substrate SUB that faces the third contact hole CT3 may not overlap the touch insulating layer TILD. Accordingly, in plan view, the first contact holes CT1 may be located between the first edge EG1 of the substrate SUB and the first extension portion EX1 of the touch insulating layer TILD, and the third contact holes CT3 may be located between the second edge EG2 of the substrate SUB and the first extension portion EX1 of the touch insulating layer TILD.

In the first bending adjacent area BAA1, at least a part of the first edge EG1 and at least a part of the second edge EG2 of the substrate SUB may not overlap the third inorganic layer YCLAD. In other words, in the first bending adjacent area BAA1, the third inorganic layer YCLAD may be positioned such that at least a part of the first edge EG1 and at least a part of the second edge EG2 of the substrate SUB remain exposed. For example, a portion of the first edge EG1 of the substrate SUB that is adjacent to the first contact hole CT1 may not overlap the third inorganic layer YCLAD, and a portion of the second edge EG2 of the substrate SUB that is adjacent to the third contact hole CT3 may not overlap the third inorganic layer YCLAD. In other words, a portion of the first edge EG1 of the substrate SUB that faces the first contact hole CT1 may not overlap the third inorganic layer YCLAD, and a portion of the second edge EG2 of the substrate SUB that faces the third contact hole CT3 may not overlap the third inorganic layer YCLAD. Accordingly, in plan view, the first contact holes CT1 may be located between the first edge EG1 of the substrate SUB and the second extension portion EX2 of the third inorganic layer YCLAD, and the third contact holes CT3 may be located between the second edge EG2 of the substrate SUB and the second extension portion EX2 of the third inorganic layer YCLAD.

In the first bending adjacent area BAA1, at least a part of the first edge EG1 and at least a part of the second edge EG2 of the substrate SUB may not overlap the overcoat layer OC. In other words, in the first bending adjacent area BAA1, the overcoat layer OC may be positioned such that at least a part of the first edge EG1 and at least a part of the second edge EG2 of the substrate SUB remain exposed. For example, a portion of the first edge EG1 of the substrate SUB that is adjacent to the first contact hole CT1 may not overlap the overcoat layer OC, and a portion of the second edge EG2 of the substrate SUB that is adjacent to the third contact hole CT3 may not overlap the overcoat layer OC. In other words, a portion of the first edge EG1 of the substrate SUB that faces the first contact hole CT1 may not overlap the overcoat layer OC, and a portion of the second edge EG2 of the substrate SUB that faces the third contact hole CT3 may not overlap the overcoat layer OC. Accordingly, in plan view, the first contact holes CT1 may be located between the first edge EG1 of the substrate SUB and the second extension portion EX2 of the overcoat layer OC, and the third contact holes CT3 may be located between the second edge EG2 of the substrate SUB and the second extension portion EX2 of the overcoat layer OC.

In the second bending adjacent area BAA2, at least a part of the first edge EG1 and at least a part of the second edge EG2 of the substrate SUB may not overlap the touch insulating layer TILD (e.g., the first inorganic layer YILD and the second inorganic layer YCNT). In other words, in the second bending adjacent area BAA2, the touch insulating layer TILD may be positioned such that at least a part of the first edge EG1 and at least a part of the second edge EG2 of the substrate SUB remain exposed. For example, a portion of the first edge EG1 of the substrate SUB that is adjacent to the fourth contact hole CT4 may not overlap the touch insulating layer TILD, and a portion of the second edge EG2 of the substrate SUB that is adjacent to the sixth contact hole CT6 may not overlap the touch insulating layer TILD. In other words, a portion of the first edge EG1 of the substrate SUB that faces the fourth contact hole CT4 may not overlap the touch insulating layer TILD, and a portion of the second edge EG2 of the substrate SUB that faces the sixth contact hole CT6 may not overlap the touch insulating layer TILD. Accordingly, in plan view, the fourth contact holes CT4 may be located between the first edge EG1 of the substrate SUB and the third extension portion EX3 of the touch insulating layer TILD, and the sixth contact holes CT6 may be located between the second edge EG2 of the substrate SUB and the third extension portion EX3 of the touch insulating layer TILD.

In the second bending adjacent area BAA2, at least a part of the first edge EG1 of the substrate SUB may not overlap the third inorganic layer YCLAD. In other words, in the second bending adjacent area BAA2, the third inorganic layer YCLAD may be positioned such that at least a part of the first edge EG1 of the substrate SUB remains exposed. For example, a portion of the first edge EG1 of the substrate SUB that is adjacent to the fourth contact hole CT4 may not overlap the third inorganic layer YCLAD. In other words, a portion of the first edge EG1 of the substrate SUB that faces the fourth contact hole CT4 may not overlap the third inorganic layer YCLAD. Accordingly, in plan view, the fourth contact holes CT4 may be located between the first edge EG1 of the substrate SUB and the fourth extension portion EX4 of the third inorganic layer YCLAD.

In the second bending adjacent area BAA2, at least a part of the first edge EG1 of the substrate SUB may not overlap the overcoat layer OC. In other words, in the second bending adjacent area BAA2, the overcoat layer OC may be positioned such that at least a part of the first edge EG1 of the substrate SUB remains exposed. For example, a portion of the first edge EG1 of the substrate SUB that is adjacent to the fourth contact hole CT4 may not overlap the overcoat layer OC. In other words, a portion of the first edge EG1 of the substrate SUB that faces the fourth contact hole CT4 may not overlap the overcoat layer OC. Accordingly, in plan view, the fourth contact holes CT4 may be located between the first edge EG1 of the substrate SUB and the fourth extension portion EX4 of the overcoat layer OC.

According to one example embodiment, in plan view as illustrated in FIG. 8, in the first bending adjacent area BAA1, the touch insulating layer TILD (e.g., the first inorganic layer YILD and the second inorganic layer YCNT) may have a substantially linear edge between the first edge EG1 of the substrate SUB and the first extension portion EX1 of the touch insulating layer TILD. For example, in the first bending adjacent area BAA1, the edge of the touch insulating layer TILD that connects the first edge EG1 of the substrate SUB to the first extension portion EX1 of the touch insulating layer TILD may form a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

According to one example embodiment, in plan view as illustrated in FIG. 8, in the first bending adjacent area BAA1, the third inorganic layer YCLAD may have a substantially linear edge between the first edge EG1 of the substrate SUB and the second extension portion EX2 of the third inorganic layer YCLAD. For example, in the first bending adjacent area BAA1, the edge of the third inorganic layer YCLAD that connects the first edge EG1 of the substrate SUB to the second extension portion EX2 of the third inorganic layer YCLAD may form a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

According to one example embodiment, in plan view as illustrated in FIG. 8, in the first bending adjacent area BAA1, the overcoat layer OC may have a substantially linear edge between the first edge EG1 of the substrate SUB and the second extension portion EX2 of the overcoat layer OC. For example, in the first bending adjacent area BAA1, the edge of the overcoat layer OC that connects the first edge EG1 of the substrate SUB to the second extension portion EX2 of the overcoat layer OC may form a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

According to one example embodiment, in plan view as illustrated in FIG. 8, in the first bending adjacent area BAA1, the touch insulating layer TILD (e.g., the first inorganic layer YILD and the second inorganic layer YCNT) may have a substantially linear edge between the second edge EG2 of the substrate SUB and the first extension portion EX1 of the touch insulating layer TILD. For example, in the first bending adjacent area BAA1, the edge of the touch insulating layer TILD that connects the second edge EG2 of the substrate SUB to the first extension portion EX1 of the touch insulating layer TILD may form a linear shape (e.g., an unbent linear shape) extending parallel to the arrangement direction of the third contact holes CT3 (or the arrangement direction of the third signal transmission lines STL3, or the second direction DR2, or the direction perpendicular to the second edge EG2).

According to one example embodiment, in plan view as illustrated in FIG. 8, in the first bending adjacent area BAA1, the third inorganic layer YCLAD may have a substantially linear edge between the second edge EG2 of the substrate SUB and the second extension portion EX2 of the third inorganic layer YCLAD. For example, in the first bending adjacent area BAA1, the edge of the third inorganic layer YCLAD that connects the second edge EG2 of the substrate SUB to the second extension portion EX2 of the third inorganic layer YCLAD may form a linear shape (e.g., an unbent linear shape) extending parallel to the arrangement direction of the third contact holes CT3 (or the arrangement direction of the third signal transmission lines STL3, or the second direction DR2, or the direction perpendicular to the second edge EG2).

According to one example embodiment, in plan view as illustrated in FIG. 8, in the first bending adjacent area BAA1, the overcoat layer OC may have a substantially linear edge between the second edge EG2 of the substrate SUB and the second extension portion EX2 of the overcoat layer OC. For example, in the first bending adjacent area BAA1, the edge of the overcoat layer OC that connects the second edge EG2 of the substrate SUB to the second extension portion EX2 of the overcoat layer OC may form a linear shape (e.g., an unbent linear shape) extending parallel to the arrangement direction of the third contact holes CT3 (or the arrangement direction of the third signal transmission lines STL3, or the second direction DR2, or the direction perpendicular to the second edge EG2).

According to one example embodiment, in plan view as illustrated in FIG. 8, in the second bending adjacent area BAA2, the touch insulating layer TILD (e.g., the first inorganic layer YILD and the second inorganic layer YCNT) may have a substantially linear edge between the first edge EG1 of the substrate SUB and the third extension portion EX3 of the touch insulating layer TILD. For example, in the second bending adjacent area BAA2, the edge of the touch insulating layer TILD that connects the first edge EG1 of the substrate SUB to the third extension portion EX3 of the touch insulating layer TILD may form a linear shape (e.g.,, an unbent linear shape) extending parallel to the arrangement direction of the fourth contact holes CT4 (or the arrangement direction of the first signal transmission lines STL1, or the second direction DR2, or the direction perpendicular to the first edge EG1).

According to one example embodiment, in plan view as illustrated in FIG. 8, in the second bending adjacent area BAA2, the third inorganic layer YCLAD may have a substantially linear edge between the first edge EG1 of the substrate SUB and the fourth extension portion EX4 of the third inorganic layer YCLAD. For example, in the second bending adjacent area BAA2, the edge of the third inorganic layer YCLAD that connects the first edge EG1 of the substrate SUB to the fourth extension portion EX4 of the third inorganic layer YCLAD may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1).

According to one example embodiment, in plan view as illustrated in FIG. 8, in the second bending adjacent area BAA2, the overcoat layer OC may have a substantially linear edge between the first edge EG1 of the substrate SUB and the fourth extension portion EX4 of the overcoat layer OC. For example, in the second bending adjacent area BAA2, the edge of the overcoat layer OC that connects the first edge EG1 of the substrate SUB to the fourth extension portion EX4 of the overcoat layer OC may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1).

According to one example embodiment, in plan view as illustrated in FIG. 8, in the second bending adjacent area BAA2, the touch insulating layer TILD (e.g., the first inorganic layer YILD and the second inorganic layer YCNT) may have a substantially linear edge between the second edge EG2 of the substrate SUB and the third extension portion EX3 of the touch insulating layer TILD. For example, in the second bending adjacent area BAA2, the edge of the touch insulating layer TILD that connects the second edge EG2 of the substrate SUB to the third extension portion EX3 of the touch insulating layer TILD may form a linear shape (e.g., an unbent linear shape) extending parallel to the arrangement direction of the sixth contact holes CT6 (or the arrangement direction of the third signal transmission lines STL3, or the second direction DR2, or the direction perpendicular to the second edge EG2).

The touch insulating layer TILD (e.g., the first inorganic layer YILD and the second inorganic layer YCND) located in the first bending adjacent area BAA1 may overlap the third inorganic layer YCLAD (and/or the overcoat layer OC) located in the first bending adjacent area BAA1.

In plan view, the touch insulating layer TILD (e.g., the first inorganic layer YILD and the second inorganic layer YCND) located in the first bending adjacent area BAA1 may have substantially the same shape as the shape of the third inorganic layer YCLAD (and/or the overcoat layer OC) located in the first bending adjacent area BAA1. However, in plan view, the area of the touch insulating layer TILD (e.g., the first inorganic layer YILD and the second inorganic layer YCND) located in the first bending adjacent area BAA1 may be larger than the area of the third inorganic layer YCLAD (and/or the overcoat layer OC) located in the first bending adjacent area BAA1.

The touch insulating layer TILD (e.g., the first inorganic layer YILD and the second inorganic layer YCND) located in the second bending adjacent area BAA2 may overlap the third inorganic layer YCLAD (and/or the overcoat layer OC) located in the second bending adjacent area BAA2.

In plan view, the area of the touch insulating layer TILD (e.g., the first inorganic layer YILD and the second inorganic layer YCND) located in the second bending adjacent area BAA2 may be smaller than the area of the third inorganic layer YCLAD (and/or the overcoat layer OC) located in the second bending adjacent area BAA2.

The above-described touch insulating layer TILD (e.g., the first inorganic layer YILD and the second inorganic layer YCNT), the third inorganic layer YCLAD, and the overcoat layer OC may not be located in the bending area BD. In other words, the first inorganic layer YILD, the second inorganic layer YCNT, the third inorganic layer YCLAD, and the overcoat layer OC may not overlap the bending area BD.

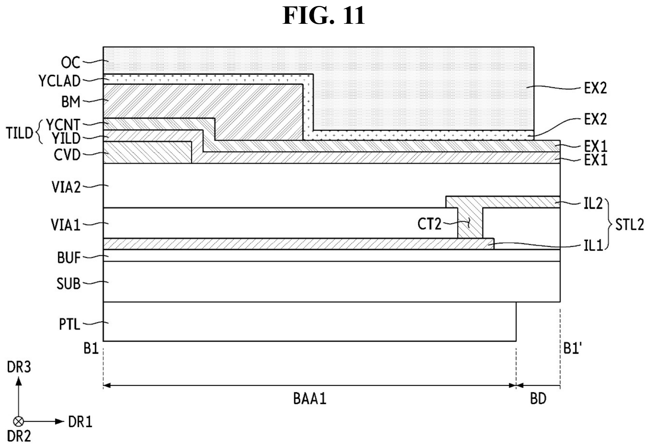

FIG. 10 is a cross-sectional view of the display device 100 taken along line A1-A1' of FIG. 8, and FIG. 11 is a cross-sectional view of the display device 100 taken along line B1-B1' of FIG. 8.

As shown in FIGS. 10 and 11, the display device 100 may include a protective layer PTL (or a substrate cover layer), the substrate SUB, the buffer layer BUF, the first signal transmission line STL1, the second signal transmission line STL2, the first via layer VIA1, the second via layer VIA2, an encapsulation layer CVD, the touch insulating layer TILD, a light blocking layer BM, the third inorganic layer YCLAD, and the overcoat layer OC.

The protective layer PTL may support the substrate SUB. In addition, the protective layer PTL may protect the bottom surface of the substrate SUB and may also serve as a light blocking layer that blocks light incident on the bottom surface of the substrate SUB. The protective layer PTL may include a material including a black pigment. The protective layer PTL may be attached to the bottom surface of the substrate SUB by an adhesive member. The adhesive member may be a pressure sensitive adhesive (PSA). In order to facilitate bending of the substrate SUB, the protective layer PTL may not be located in the bending area BD of the substrate SUB.

The substrate SUB may be located on the protective layer PTL. The substrate SUB may be a base substrate or a base member. The substrate SUB may be a flexible substrate SUB which can be bent, folded or rolled. For example, the substrate SUB may include a polymer resin such as polyimide (PI), but is not limited thereto. For another example, the substrate SUB may include a glass material or a metal material.

The buffer layer BUF may be located on the substrate SUB. The description of the buffer layer BUF refer to the description of the buffer layer BUF of FIG. 4 described above.

The first signal transmission line STL1 and the second signal transmission line STL2 may be located on the buffer layer BUF. The first signal transmission line STL1 may include a first interlayer line IL1 and a second interlayer line IL2 on different layers in the third direction DR3, and the second signal transmission line STL2 may include a first interlayer line IL1 and a second interlayer line IL2 on different layers in the third direction DR3.

The first interlayer line IL1 of the first signal transmission line STL1 and the first interlayer line IL1 of the second signal transmission line STL2 may be located on the buffer layer BUF. Each first interlayer line IL1 may include a conductive material.

The first via layer VIA1 may be located on each first interlayer line IL1.

The second interlayer line IL2 of the first signal transmission line STL1 and the second interlayer line IL2 of the second signal transmission line STL2 may be located on the first via layer VIA1. The second interlayer line IL2 of the first signal transmission line STL1 may be located on the first via layer VIA1 to overlap the first interlayer line IL1 of the first signal transmission line STL1, and the second interlayer line IL2 of the second signal transmission line STL2 may be located on the first via layer VIA1 to overlap the first interlayer line IL1 of the second signal transmission line STL2.

The second interlayer line IL2 of the first signal transmission line STL1 may be connected to the first interlayer line IL1 of the first signal transmission line STL1 through the first contact hole CT1 penetrating the first via layer VIA1, and the second interlayer line IL2 of the second signal transmission line STL2 may be connected to the first interlayer line IL1 of the second signal transmission line STL2 through the second contact hole CT2 penetrating the first via layer VIA1.

The second via layer VIA2 may be located on each second interlayer line IL2.

The encapsulation layer CVD may be located on the second via layer VIA2. The encapsulation layer CVD may include one or more inorganic encapsulation layers and one or more organic encapsulation layers. The encapsulation layer CVD of the first bending adjacent area BAA1 may include two inorganic encapsulation layers bonded to each other.

The touch insulating layer TILD may be located on the encapsulation layer CVD. The touch insulating layer TILD may include the first inorganic layer YILD and the second inorganic layer YCNT on the first inorganic layer YILD. The first inorganic layer YILD and the second inorganic layer YCNT may include different inorganic materials. As illustrated in FIG. 8, the edge of the first inorganic layer YILD and the edge of the second inorganic layer YCNT may overlap (or coincide with each other).

The light blocking layer BM may be located on the touch insulating layer TILD. The light blocking layer BM may block light from the outside.

The third inorganic layer YCLAD may be located on the light blocking layer BM.

The overcoat layer OC may be located on the third inorganic layer YCLAD. As illustrated in FIG. 8, the edge of the overcoat layer OC and the edge of the third inorganic layer YCLAD may overlap (or coincide with each other).

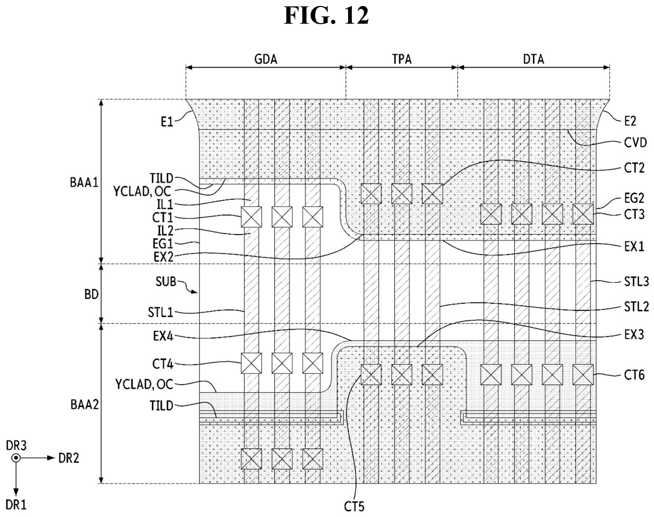

FIG. 12 is an enlarged view of another example embodiment of area X1 of FIG. 6.

The display device 100 of FIG. 12 is different from the display device 100 of FIG. 8 described above in the shapes of the touch insulating layer TILD, the third inorganic layer YCLAD, and the overcoat layer OC in the first bending adjacent area BAA1, and the following description will mainly focus on this difference.

As illustrated in FIG. 12, in the first bending adjacent area BAA1, the touch insulating layer TILD (e.g., the first inorganic layer YILD and the second inorganic layer YCNT) may include the first extension portion EX1 overlapping the second contact holes CT2 and the third contact holes CT3. In this case, the touch insulating layer TILD may overlap the second edge EG2 of the substrate SUB in the first bending adjacent area BAA1.

As illustrated in FIG. 12, in the first bending adjacent area BAA1, the third inorganic layer YCLAD may include the second extension portion EX2 overlapping the second contact holes CT2 and the third contact holes CT3. In this case, the third inorganic layer YCLAD may overlap the second edge EG2 of the substrate SUB in the first bending adjacent area BAA1.

As illustrated in FIG. 12, in the first bending adjacent area BAA1, the overcoat layer OC may include the second extension portion EX2 overlapping the second contact holes CT2 and the third contact holes CT3. In this case, the overcoat layer OC may overlap the second edge EG2 of the substrate SUB in the first bending adjacent area BAA1.

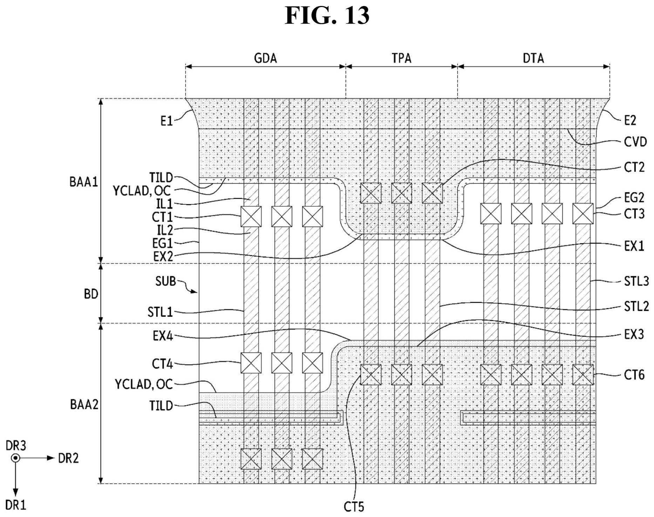

FIG. 13 is an enlarged view of another example embodiment of area X1 of FIG. 6.

The display device 100 of FIG. 13 is different from the display device 100 of FIG. 8 described above in the shape of the touch insulating layer TILD in the second bending adjacent area BAA2, and the following description will mainly focus on this difference.

As illustrated in FIG. 13, the shape of the touch insulating layer TILD (e.g., the first inorganic layer YILD and the second inorganic layer YCNT) located in the second bending adjacent area BAA2 may be substantially the same as the shape of the third inorganic layer YCLAD (and/or the overcoat layer OC) located in the second bending adjacent area BAA2. However, the area of the third inorganic layer YCLAD (and/or the overcoat layer OC) located in the second bending adjacent area BAA2 may be larger than the area of the touch insulating layer TILD (e.g., the first inorganic layer YILD and the second inorganic layer YCNT) located in the second bending adjacent area BAA2.

As illustrated in FIG. 13, in the second bending adjacent area BAA2, the touch insulating layer TILD (e.g., the first inorganic layer YILD and the second inorganic layer YCNT) may include the third extension portion EX3 overlapping the fifth contact holes CT5 and the sixth contact holes CT6. In this case, the touch insulating layer TILD may overlap the second edge EG2 of the substrate SUB in the second bending adjacent area BAA2.

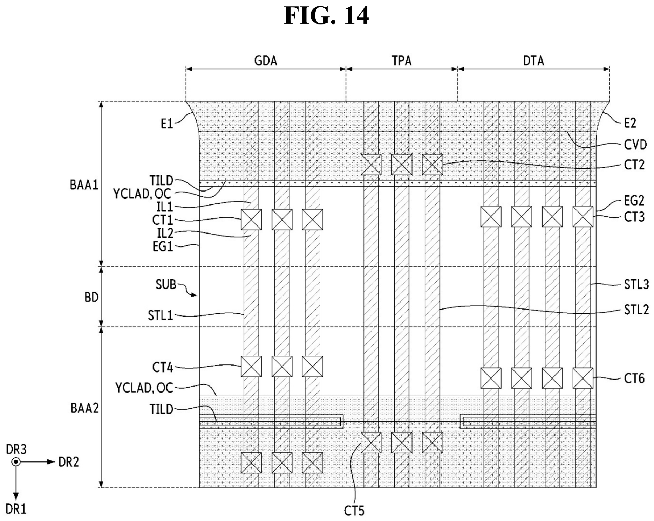

FIG. 14 is an enlarged view of another example embodiment of area X1 of FIG. 6.

The display device 100 of FIG. 14 is different from the display device 100 of FIG. 8 described above in the shape of the touch insulating layer TILD, the shape of the third inorganic layer YCLAD, and the shape of the overcoat layer OC in the first bending adjacent area BAA1 and the second bending adjacent area BAA2, and the following description will mainly focus on this difference.

As illustrated in FIG. 14, the edge of the touch insulating layer TILD (e.g., the first inorganic layer YILD and the second inorganic layer YCNT) in the first bending adjacent area BAA1 may have a linear shape. For example, according to one example embodiment, in plan view as illustrated in FIG. 14, in the first bending adjacent area BAA1, the touch insulating layer TILD may have a substantially linear edge between the first edge EG1 of the substrate SUB and the second edge EG2 of the substrate SUB. For example, in the first bending adjacent area BAA1, the edge of the touch insulating layer TILD that connects the first edge EG1 of the substrate SUB to the second edge EG2 of the substrate SUB may have a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

As illustrated in FIG. 14, the edge of the third inorganic layer YCLAD in the first bending adjacent area BAA1 may have a linear shape. For example, according to one example embodiment, in plan view as illustrated in FIG. 14, in the first bending adjacent area BAA1, the third inorganic layer YCLAD may have a substantially linear edge between the first edge EG1 of the substrate SUB and the second edge EG2 of the substrate SUB. For example, in the first bending adjacent area BAA1, the edge of the third inorganic layer YCLAD that connects the first edge EG1 of the substrate SUB to the second edge EG2 of the substrate SUB may have a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1). In other words, in the first bending adjacent area BAA1, the edge of the third inorganic layer YCLAD may be parallel to the edge of the touch insulating layer TILD.

As illustrated in FIG. 14, the edge of the overcoat layer OC in the first bending adjacent area BAA1 may have a linear shape. For example, according to one example embodiment, in plan view as illustrated in FIG. 14, in the first bending adjacent area BAA1, the overcoat layer OC may have a substantially linear edge between the first edge EG1 of the substrate SUB and the second edge EG2 of the substrate SUB. For example, in the first bending adjacent area BAA1, the edge of the overcoat layer OC that connects the first edge EG1 of the substrate SUB to the second edge EG2 of the substrate SUB may have a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1). In other words, in the first bending adjacent area BAA1, the edge of the overcoat layer OC may be parallel to the edge of the touch insulating layer TILD.

As illustrated in FIG. 14, the edge of the touch insulating layer TILD (e.g., the first inorganic layer YILD and the second inorganic layer YCNT) in the second bending adjacent area BAA2 may have a linear shape. For example, according to one example embodiment, in plan view as illustrated in FIG. 14, in the second bending adjacent area BAA2, the touch insulating layer TILD may have a substantially linear edge between the first edge EG1 of the substrate SUB and the second edge EG2 of the substrate SUB. For example, in the second bending adjacent area BAA2, the edge of the touch insulating layer TILD that connects the first edge EG1 of the substrate SUB to the second edge EG2 of the substrate SUB may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1).

As illustrated in FIG. 14, the edge of the third inorganic layer YCLAD in the second bending adjacent area BAA2 may have a linear shape. For example, according to one example embodiment, in plan view as illustrated in FIG. 14, in the second bending adjacent area BAA2, the third inorganic layer YCLAD may have a substantially linear edge between the first edge EG1 of the substrate SUB and the second edge EG2 of the substrate SUB. For example, in the second bending adjacent area BAA2, the edge of the third inorganic layer YCLAD that connects the first edge EG1 of the substrate SUB to the second edge EG2 of the substrate SUB may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1). In other words, in the second bending adjacent area BAA2, the edge of the third inorganic layer YCLAD may be parallel to the edge of the touch insulating layer TILD.

As illustrated in FIG. 14, the edge of the overcoat layer OC in the second bending adjacent area BAA2 may have a linear shape. For example, according to one example embodiment, in plan view as illustrated in FIG. 14, in the second bending adjacent area BAA2, the overcoat layer OC may have a substantially linear edge between the first edge EG1 of the substrate SUB and the second edge EG2 of the substrate SUB. For example, in the second bending adjacent area BAA2, the edge of the overcoat layer OC that connects the first edge EG1 of the substrate SUB to the second edge EG2 of the substrate SUB may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1). In other words, in the first bending adjacent area BAA1, the edge of the overcoat layer OC may be parallel to the edge of the touch insulating layer TILD.

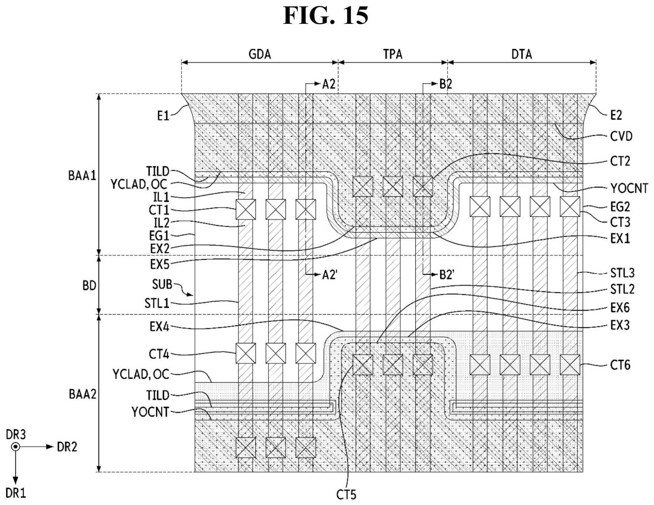

FIG. 15 is an enlarged view of another example embodiment of area X1 of FIG. 6.

The display device 100 of FIG. 15 is different from the display device 100 of FIG. 8 described above in that an organic layer YOCNT is further included, and the following description will mainly focus on this difference.

As illustrated in FIG. 15, the organic layer YOCNT may be further located in the first bending adjacent area BAA1 and the second bending adjacent area BAA2.

In plan view, the organic layer YOCNT of the first bending adjacent area BAA1 may have substantially the same shape as the shape of the touch insulating layer TILD (e.g., the first inorganic layer YILD and the second inorganic layer YCNT) located in the first bending adjacent area BAA1. However, the area of the organic layer YOCNT located in the first bending adjacent area BAA1 may be larger than the area of the touch insulating layer TILD located in the first bending adjacent area BAA1.

The organic layer YOCNT located in the first bending adjacent area BAA1 may include a fifth extension portion EX5 overlapping the second contact holes CT2.

In plan view, the edge of the touch insulating layer TILD located in the first bending adjacent area BAA1 may be located between the edge of the third inorganic layer YCLAD (and/or the overcoat layer OC) located in the first bending adjacent area BAA1 and the edge of the organic layer YOCNT located in the first bending adjacent area BAA1.

According to one example embodiment, in plan view as illustrated in FIG. 15, in the first bending adjacent area BAA1, the organic layer YOCNT may have a substantially linear edge between the first edge EG1 of the substrate SUB and the fifth extension portion EX5 of the organic layer YOCNT. For example, in the first bending adjacent area BAA1, the edge of the organic layer YOCNT that connects the first edge EG1 of the substrate SUB to the fifth extension portion EX5 of the organic layer YOCNT may form a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

According to one example embodiment, in plan view as illustrated in FIG. 15, in the first bending adjacent area BAA1, the organic layer YOCNT may have a substantially linear edge between the second edge EG2 of the substrate SUB and the fifth extension portion EX5 of the organic layer YOCNT. For example, in the first bending adjacent area BAA1, the edge of the organic layer YOCNT that connects the second edge EG2 of the substrate SUB to the fifth extension portion EX5 of the organic layer YOCNT may form a linear shape (e.g., an unbent linear shape) extending parallel to the arrangement direction of the third contact holes CT3 (or the arrangement direction of the third signal transmission lines STL3, or the second direction DR2, or the direction perpendicular to the second edge EG2).

In plan view, the organic layer YOCNT in the second bending adjacent area BAA2 may have substantially the same shape as the shape of the touch insulating layer TILD (e.g., the first inorganic layer YILD and the second inorganic layer YCNT) located in the second bending adjacent area BAA2. However, the area of the organic layer YOCNT located in the second bending adjacent area BAA2 may be smaller than the area of the touch insulating layer TILD located in the second bending adjacent area BAA2.

The organic layer YOCNT located in the second bending adjacent area BAA2 may include a sixth extension portion EX6 overlapping the fifth contact holes CT5.

In plan view, the edge of the touch insulating layer TILD located in the second bending adjacent area BAA2 may be located between the edge of the third inorganic layer YCLAD (and/or the overcoat layer OC) located in the second bending adjacent area BAA2 and the edge of the organic layer YOCNT located in the second bending adjacent area BAA2.

According to one example embodiment, in plan view as illustrated in FIG. 15, in the second bending adjacent area BAA2, the organic layer YOCNT may have a substantially linear edge between the first edge EG1 of the substrate SUB and the sixth extension portion EX6 of the organic layer YOCNT. For example, in the second bending adjacent area BAA2, the edge of the organic layer YOCNT that connects the first edge EG1 of the substrate SUB to the sixth extension portion EX6 of the organic layer YOCNT may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1).

According to one example embodiment, in plan view as illustrated in FIG. 15, in the second bending adjacent area BAA2, the organic layer YOCNT may have a substantially linear edge between the second edge EG2 of the substrate SUB and the sixth extension portion EX6 of the organic layer YOCNT. For example, in the second bending adjacent area BAA2, the edge of the organic layer YOCNT that connects the second edge EG2 of the substrate SUB to the sixth extension portion EX6 of the organic layer YOCNT may form a linear shape (e.g., an unbent linear shape) extending parallel to the arrangement direction of the sixth contact holes CT6 (or the arrangement direction of the third signal transmission lines STL3, or the second direction DR2, or the direction perpendicular to the second edge EG2).

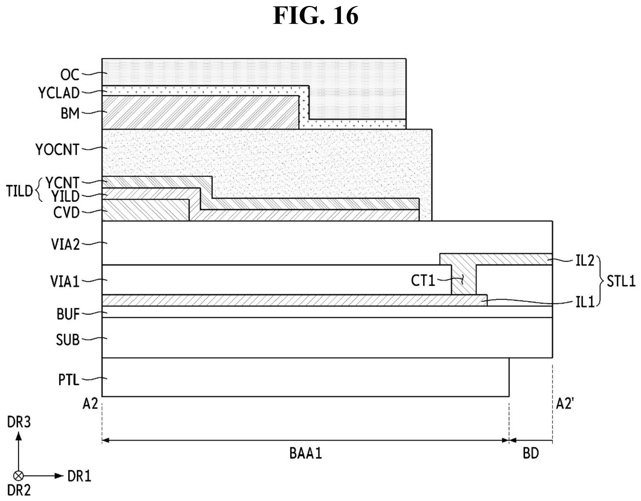

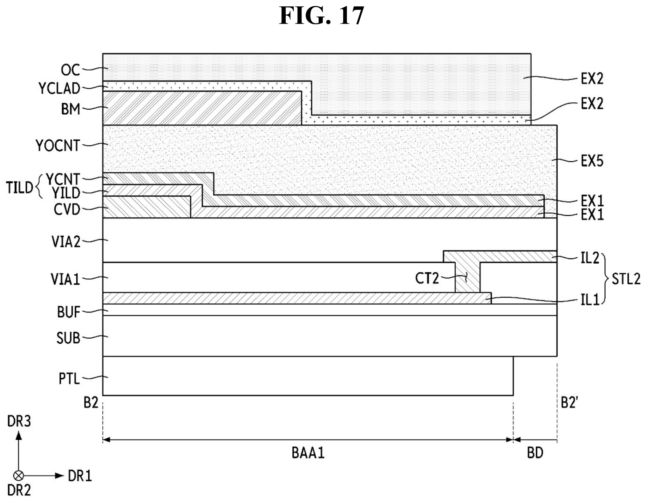

FIG. 16 is a cross-sectional view of the display device 100 taken along line A2-A2' of FIG. 15, and FIG. 17 is a cross-sectional view of the display device 100 taken along line B2-B2' of FIG. 15.

The display device 100 of FIGS. 16 and 17 is different from the display device 100 of FIGS. 10 and 11 described above in that the organic layer YOCNT is further included, and the following description will mainly focus on this difference.

As illustrated in FIGS. 16 and 17, the organic layer YOCNT may be located on the touch insulating layer TILD (e.g., the second inorganic layer YCNT) and the second via layer VIA2.

The organic layer YOCNT may be located between the touch insulating layer TILD (e.g., the second inorganic layer YCNT) and the light blocking layer BM. In addition, the organic layer YOCNT may be located between the touch insulating layer TILD (e.g., the second inorganic layer YCNT) and the third inorganic layer YCLAD.

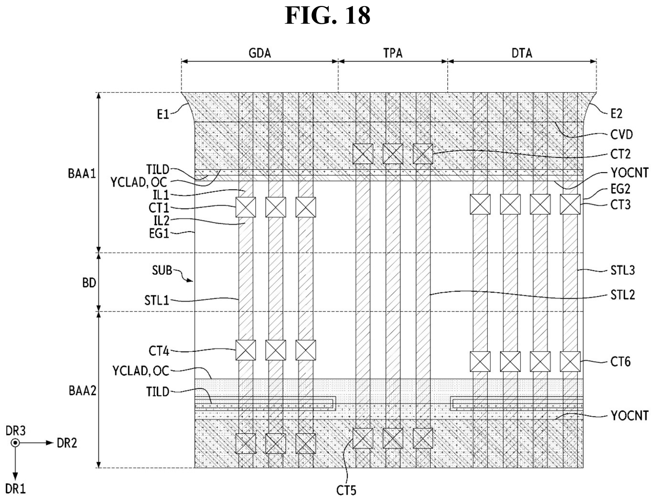

FIG. 18 is an enlarged view of another example embodiment of area X1 of FIG. 6.

The display device 100 of FIG. 18 is different from the display device 100 of FIG. 14 described above in that it further includes the organic layer YOCNT. The following description will mainly focus on this difference.

As illustrated in FIG. 18, the organic layer YOCNT may be further located in the first bending adjacent area BAA1 and the second bending adjacent area BAA2.

As illustrated in FIG. 18, the edge of the organic layer YOCNT in the first bending adjacent area BAA1 may have a linear shape. For example, according to one example embodiment, in plan view as illustrated in FIG. 18, in the first bending adjacent area BAA1, the organic layer YOCNT may have a substantially linear edge between the first edge EG1 of the substrate SUB and the second edge EG2 of the substrate SUB. For example, in the first bending adjacent area BAA1, the edge of the organic layer YOCNT that connects the first edge EG1 of the substrate SUB to the second edge EG2 of the substrate SUB may have a linear shape (e.g., an unbent linear shape) extending parallel to the arrangement direction of the first contact holes CT1 (or the arrangement direction of the first signal transmission lines STL1, or the second direction DR2, or the direction perpendicular to the first edge EG1).

As illustrated in FIG. 18, the edge of the organic layer YOCNT in the second bending adjacent area BAA2 may have a linear shape. For example, according to one example embodiment, in plan view as illustrated in FIG. 18, in the second bending adjacent area BAA2, the organic layer YOCNT may have a substantially linear edge between the first edge EG1 of the substrate SUB and the second edge EG2 of the substrate SUB. For example, in the second bending adjacent area BAA2, the edge of the organic layer YOCNT that connects the first edge EG1 of the substrate SUB to the second edge EG2 of the substrate SUB may form a linear shape (e.g., an unbent linear shape) extending parallel to the arrangement direction of the fourth contact holes CT4 (or the arrangement direction of the first signal transmission lines STL1, or the second direction DR2, or the direction perpendicular to the first edge EG1).

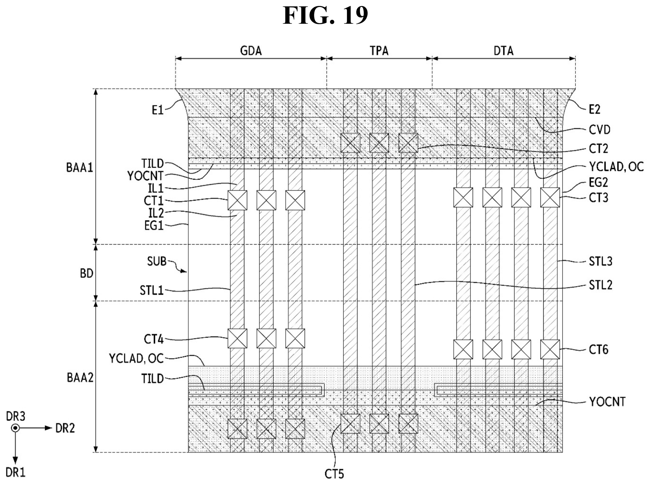

FIG. 19 is an enlarged view of another example embodiment of area X1 of FIG. 6.

The display device 100 of FIG. 19 is different from the display device 100 of FIG. 18 described above in that the area of the organic layer YOCNT located in the first bending adjacent area BAA1 is different, and the following description will mainly focus on this difference.

For example, in plan view as illustrated in FIG. 19, the area of the organic layer YOCNT located in the first bending adjacent area BAA1 may be larger than the area of the third inorganic layer YCLAD (and/or the overcoat layer OC) located in the first bending adjacent area BAA1, and may be smaller than the area of the touch insulating layer TILD (e.g., the first inorganic layer YILD and the second inorganic layer YCNT) located in the first bending adjacent area BAA1. In this case, the edge of the organic layer YOCNT located in the first bending adjacent area BAA1 may be located between the edge of the third inorganic layer YCLAD (and/or the overcoat layer OC) located in the first bending adjacent area BAA1 and the edge of the touch insulating layer TILD (e.g., the first inorganic layer YILD and the second inorganic layer YCNT) located in the first bending adjacent area BAA1.

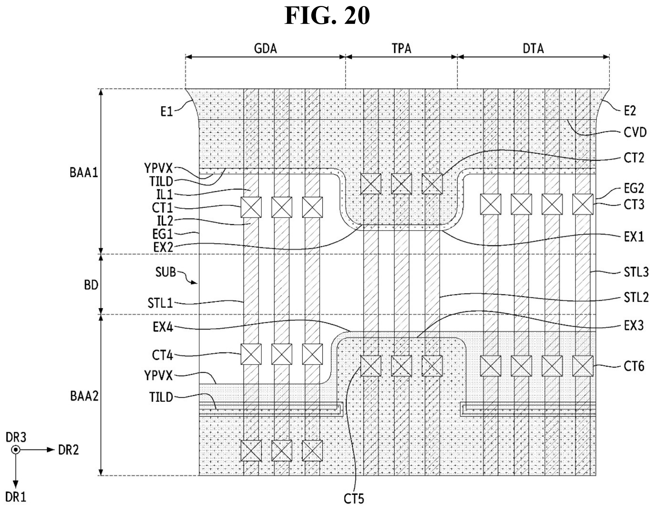

FIG. 20 is an enlarged view of another example embodiment of area X1 of FIG. 6.

The display device 100 of FIG. 20 is different from the display device 100 of FIG. 8 described above in that a passivation layer YPVX is included instead of the third inorganic layer YCLAD and the overcoat layer OC, and the following description will mainly focus on this difference.

As illustrated in FIG. 20, the passivation layer YPVX may be located in the first bending adjacent area BAA1 and the second bending adjacent area BAA2. The passivation layer YPVX may include an organic material. The passivation layer YPVX may be the same as the passivation layer TPVX of FIG. 5 described above.

As illustrated in FIG. 20, the passivation layer YPVX located in the first bending adjacent area BAA1 may overlap the touch insulating layer TILD (e.g., the first inorganic layer YILD and the second inorganic layer YCNT) located in the first bending adjacent area BAA1.

As shown in FIG. 20, in plan view, the shape of the passivation layer YPVX located in the first bending adjacent area BAA1 may be substantially the same as the shape of the touch insulating layer TILD (e.g., the first inorganic layer YILD and the second inorganic layer YCNT) located in the first bending adjacent area BAA1. However, the area of the passivation layer YPVX located in the first bending adjacent area BAA1 may be larger than the area of the touch insulating layer TILD (e.g., the first inorganic layer YILD and the second inorganic layer YCNT) located in the first bending adjacent area BAA1.

As shown in FIG 20, in plan view, the edge of the passivation layer YPVX located in the first bending adjacent area BAA1 may be located between the edge of the touch insulating layer TILD (e.g., the first inorganic layer YILD and the second inorganic layer YCNT) located in the first bending adjacent area BAA1 and the bending area BD.

As shown in FIG. 20, the passivation layer YPVX located in the first bending adjacent area BAA1 does not overlap the first edge EG1 of the substrate SUB and the second edge EG2 of the substrate SUB. In other words, the passivation layer YPVX located in the first bending adjacent area BAA1 may be positioned such that the first edge EG1 of the substrate SUB and the second edge EG2 of the substrate SUB remain exposed. The description of the passivation layer YPVX located in the first bending adjacent area BAA1 refers to the description of the touch insulating layer TILD located in the first bending adjacent area BAA1 of FIG. 8 described above.

As illustrated in FIG. 20, the passivation layer YPVX located in the second bending adjacent area BAA2 may overlap the touch insulating layer TILD (e.g., the first inorganic layer YILD and the second inorganic layer YCNT) located in the second bending adjacent area BAA2.

In plan view as illustrated in FIG. 20, the shape of the passivation layer YPVX located in the second bending adjacent area BAA2 may be substantially the same as the shape of the touch insulating layer TILD (e.g., the first inorganic layer YILD and the second inorganic layer YCNT) located in the second bending adjacent area BAA2. However, the area of the passivation layer YPVX located in the second bending adjacent area BAA2 may be larger than the area of the touch insulating layer TILD (e.g., the first inorganic layer YILD and the second inorganic layer YCNT) located in the second bending adjacent area BAA2.

In plan view as illustrated in FIG. 20, the edge of the passivation layer YPVX located in the second bending adjacent area BAA2 may be located between the edge of the touch insulating layer TILD (e.g., the first inorganic layer YILD and the second inorganic layer YCNT) located in the second bending adjacent area BAA2 and the bending area BD.

As illustrated in FIG. 20, the passivation layer YPVX located in the second bending adjacent area BAA2 does not overlap the first edge EG1 of the substrate SUB. In other words, the passivation layer YPVX located in the second bending adjacent area BAA2 may be positioned such that the first edge EG1 of the substrate SUB remains exposed. The description of the passivation layer YPVX located in the second bending adjacent area BAA2 refer to the description of the touch insulating layer TILD located in the second bending adjacent area BAA2 of FIG. 8 described above.

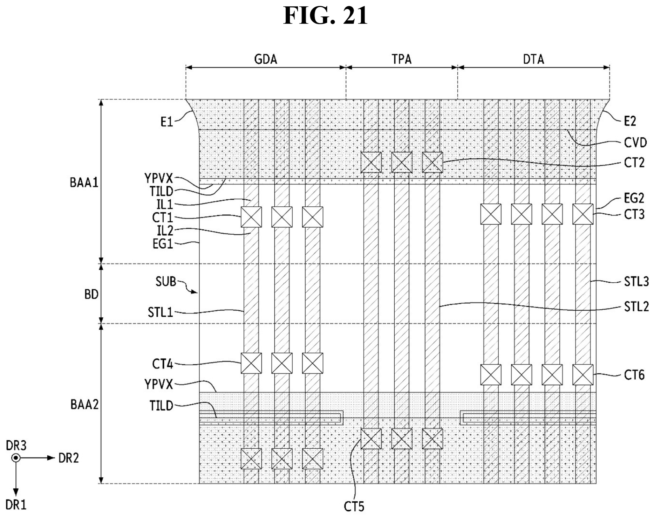

FIG. 21 is an enlarged view of another example embodiment of area X1 of FIG. 6.

The display device 100 of FIG. 21 is different from the display device 100 of FIG. 14 described above in that the passivation layer YPVX is included instead of the third inorganic layer YCLAD and the overcoat layer OC, and the following description will mainly focus on this difference.

As illustrated in FIG. 21, the passivation layer YPVX may be located in the first bending adjacent area BAA1 and the second bending adjacent area BAA2. The passivation layer YPVX may include an organic material. The passivation layer YPVX may be the same as the passivation layer TPVX of FIG. 5 described above.

As illustrated in FIG. 21, the passivation layer YPVX located in the first bending adjacent area BAA1 may overlap the touch insulating layer TILD (e.g., the first inorganic layer YILD and the second inorganic layer YCNT) located in the first bending adjacent area BAA1.

As shown in FIG. 21, in plan view, the shape of the passivation layer YPVX located in the first bending adjacent area BAA1 may be substantially the same as the shape of the touch insulating layer TILD (e.g., the first inorganic layer YILD and the second inorganic layer YCNT) located in the first bending adjacent area BAA1. However, the area of the passivation layer YPVX located in the first bending adjacent area BAA1 may be larger than the area of the touch insulating layer TILD (e.g., the first inorganic layer YILD and the second inorganic layer YCNT) located in the first bending adjacent area BAA1.

As shown in FIG 21, in plan view, the edge of the passivation layer YPVX located in the first bending adjacent area BAA1 may be located between the edge of the touch insulating layer TILD (e.g., the first inorganic layer YILD and the second inorganic layer YCNT) located in the first bending adjacent area BAA1 and the bending area BD.

As shown in FIG. 21, the passivation layer YPVX located in the first bending adjacent area BAA1 does not overlap the first edge EG1 of the substrate SUB and the second edge EG2 of the substrate SUB. In other words, the passivation layer YPVX located in the first bending adjacent area BAA1 may be positioned such that the first edge EG1 of the substrate SUB and the second edge EG2 of the substrate SUB remain exposed. The description of the passivation layer YPVX located in the first bending adjacent area BAA1 refers to the description of the touch insulating layer TILD located in the first bending adjacent area BAA1 of FIG. 14 described above.

As illustrated in FIG. 21, the passivation layer YPVX located in the second bending adjacent area BAA2 may overlap the touch insulating layer TILD (e.g., the first inorganic layer YILD and the second inorganic layer YCNT) located in the second bending adjacent area BAA2.

In plan view as illustrated in FIG. 21, the shape of the passivation layer YPVX located in the second bending adjacent area BAA2 may be substantially the same as the shape of the touch insulating layer TILD (e.g., the first inorganic layer YILD and the second inorganic layer YCNT) located in the second bending adjacent area BAA2. However, the area of the passivation layer YPVX located in the second bending adjacent area BAA2 may be larger than the area of the touch insulating layer TILD (e.g., the first inorganic layer YILD and the second inorganic layer YCNT) located in the second bending adjacent area BAA2.

In plan view as illustrated in FIG. 21, the edge of the passivation layer YPVX located in the second bending adjacent area BAA2 may be located between the edge of the touch insulating layer TILD (e.g., the first inorganic layer YILD and the second inorganic layer YCNT) located in the second bending adjacent area BAA2 and the bending area BD.

As shown in FIG. 21, the passivation layer YPVX located in the second bending adjacent area BAA2 does not overlap the first edge EG1 and the second edge EG2 of the substrate SUB. In other words, the passivation layer YPVX located in the second bending adjacent area BAA2 may be positioned such that the first edge EG1 and the second edge EG2 of the substrate SUB remain exposed. The description of the passivation layer YPVX located in the second bending adjacent area BAA2 refer to the description of the touch insulating layer TILD located in the second bending adjacent area BAA2 of FIG. 8 described above.

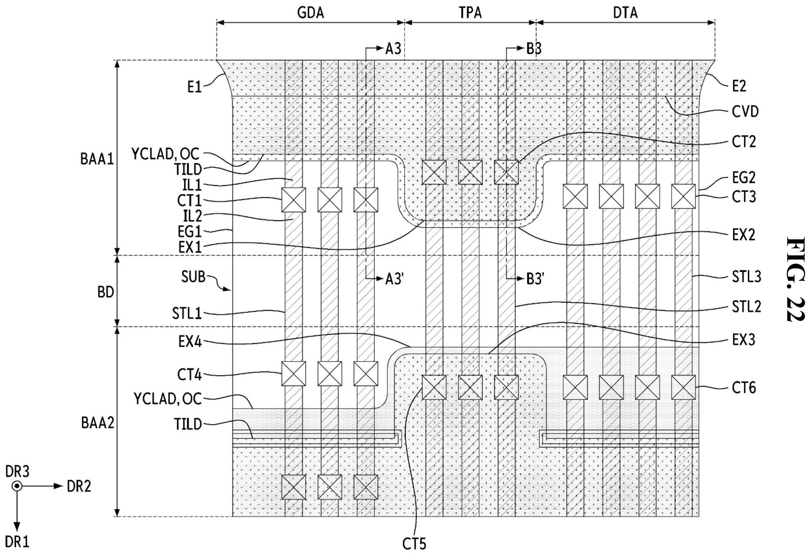

FIG. 22 is an enlarged view of another example embodiment of area X1 of FIG. 6.

The display device 100 of FIG. 22 is different from the display device 100 of FIG. 8 described above in that the position of the touch insulating layer TILD (e.g., the first inorganic layer YILD and the second inorganic layer YCNT) located in the first bending adjacent area BAA1 and the position of the third inorganic layer YCLAD (and/or the overcoat layer OC) located in the first bending adjacent area BAA1 are opposite to each other, and the following description will mainly focus on this difference.

As illustrated in FIG. 22, in plan view, the area of the third inorganic layer YCLAD (and/or the overcoat layer OC) located in the first bending adjacent area BAA1 may be larger than the area of the touch insulating layer TILD (e.g., the first inorganic layer YILD and the second inorganic layer YCNT) located in the first bending adjacent area BAA1.

As illustrated in FIG. 22, in plan view, the edge of the third inorganic layer YCLAD (and/or the overcoat layer OC) located in the first bending adjacent area BAA1 may be located between the edge of the touch insulating layer TILD (e.g., the first inorganic layer YILD and the second inorganic layer YCNT) located in the first bending adjacent area BAA1 and the bending area BD.

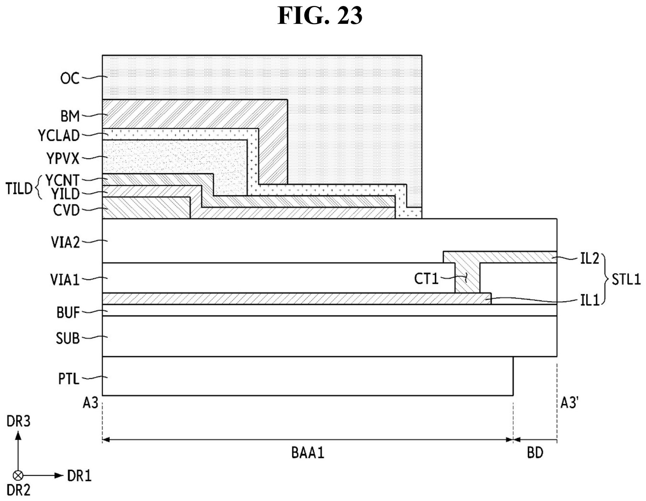

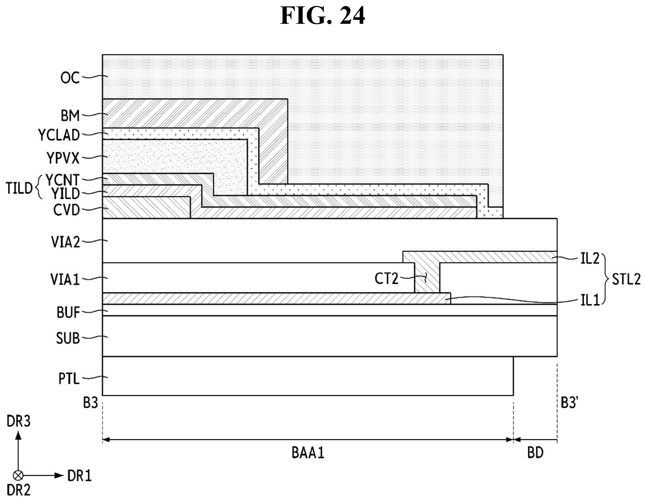

FIG. 23 is a cross-sectional view of the display device 100 taken along line A3-A3' of FIG. 22, and FIG. 24 is a cross-sectional view of the display device 100 taken along line B3-B3' of FIG. 22.

The display device 100 of FIGS. 23 and 24 is different from the display device 100 of FIGS. 10 and 11 described above in that it further includes the passivation layer YPVX. The following description will mainly focus on this difference.

As illustrated in FIG. 23 and FIG. 24, the passivation layer YPVX may be located on the touch insulating layer TILD (e.g., the second inorganic layer YCNT) and the second via layer VIA2.

The passivation layer YPVX may be located between the touch insulating layer TILD (e.g., the second inorganic layer YCNT) and the third inorganic layer YCLAD.

According to one example embodiment, the insulating layer (e.g., at least one of TILD, YCLAD, and OC) is not located at the edge of the substrate SUB in the first bending adjacent area BAA1 and the second bending adjacent area BAA2 adjacent to the bending area BD. The edge (e.g., the first edge EG1 and the second edge EG2 of the substrate SUB) of the first bending adjacent area BAA1 and the edge (e.g., the first edge EG1 and the second edge EG2 of the substrate SUB) of the second bending adjacent area BAA2 are portions to which an excessive stress is applied when the substrate (or the display panel) is bent. Therefore, when an insulating layer is formed on the edges EG1 and EG2 of the substrate SUB in the first bending adjacent area BAA1 and the second bending adjacent area BAA2, cracks may occur in the insulating layer of the edges. For example, when the display panel DP is bent with respect to the bending area BD, cracks may occur in the insulating layer due to the bending stress. The cracks in the insulating layer may propagate to the signal transmission lines STL1, STL2, and STL3 that overlap the insulating layers. In this case, the signal transmission lines STL1, STL2, and STL3 may be damaged. However, according to one example embodiment, an insulating layer is not formed at portions of the first edge EG1 and the second edge EG2 of the substrate SUB to which an excessive bending stress is applied, particularly at portions facing the outermost contact holes (e.g., the first contact hole CT1, the third contact hole CT3, the fourth contact hole CT4, and the sixth contact hole CT6), thereby reducing or preventing the propagation of cracks occurring in the insulating layer. Accordingly, the damage to the signal transmission lines STL1, STL2, and STL3 in the bending area BD and its vicinity (e.g., the first bending adjacent area BAA1, the second bending adjacent area BAA2) may be reduced or prevented.

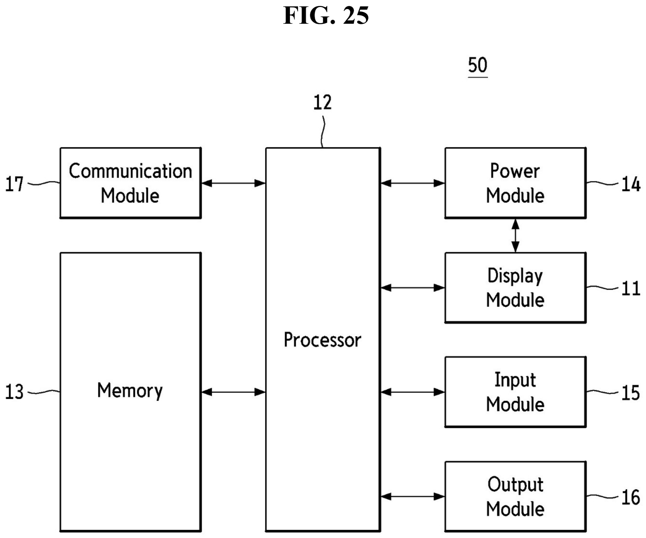

FIG. 25 is a block diagram of an electronic device according to one example embodiment. Referring to FIG. 25, an electronic device 50 according to one example embodiment may include a display module 11, a processor 12, a memory 13, and a power module 14. The electronic device 50 may further include an input module 15, a non-visual output module 16, and/or a communication module 17.

The electronic device 50 may output various information in the form of images through the display module 11. When the processor 12 executes an application stored in the memory 13, image information provided by the application may be provided to a user through the display module 11. The power module 14 may include a power supply module, such as a power adapter or a battery device, and a power conversion module that converts the power supplied by the power supply module to generate the power desired for the operation of the electronic device 50. The input module 15 may provide input information to the processor 12 and/or the display module 11. The non-visual output module 16 may serve to receive information other than images, such as sound, haptics, luminescence, etc., sent from the processor 12, and provide it to the user. The communication module 17 is a module responsible for the transmission and reception of information between the electronic device 50 and an external device, and may include a receiver and a transmitter.

At least one of the respective components of the electronic device 50 described above may be included in the display device according to the example embodiments described above. Further, some of individual modules functionally included in one module may be included in the display device and some others may be provided separately from the display device. For example, the display device may include the display module 11, whereas the processor 12, the memory 13 and the power module 14 may be provided in the form of other devices in the electronic device 50, other than the display device.

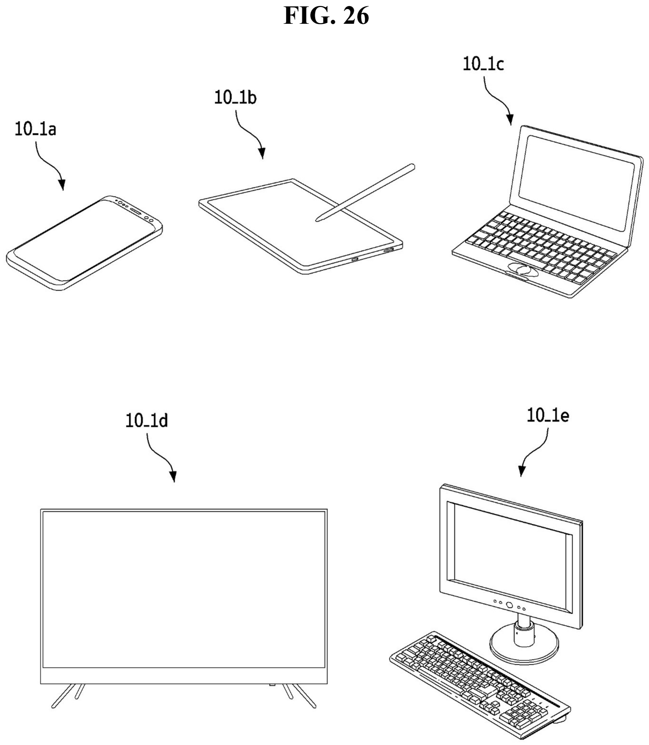

FIGS. 26, 27 and 28 are schematic diagrams illustrating electronic devices according to various example embodiments. FIGS. 26 to 28 illustrate examples of various electronic devices to which the display device 10 according to the above-described example embodiments are applied.

FIG. 26 shows a smartphone 10_1a, a tablet PC 10_1b, a laptop 10_1c, a TV 10_1d, and a desk monitor 10_1e as examples of electronic devices.

The smartphone 10_1a may include a communication module and an input module such as a touch sensor, etc., in addition to the display module 11. The smartphone 10_1a may process the information received through the communication module or input module and display the processed information through the display module of the display device.

Each of the tablet PC 10_1b, the laptop 10_1c, the TV 10_1d, and the desk monitor 10_1e may include a display and an input module, similarly to the smartphone 10_1a, and may further include a communication module in some cases.

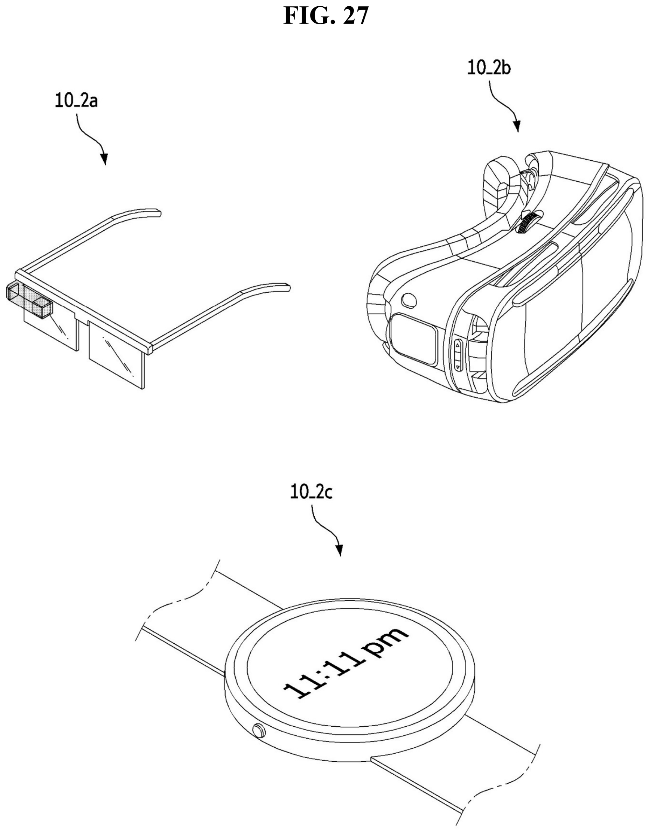

FIG. 27 illustrates a case in which an electronic device including a display module is applied to a wearable electronic device. The wearable electronic device may be smart glasses 10_2a, a head mounted display 10_2b, a smart watch 10_2c, and the like.

The smart glasses 10_2a and the head mounted display 10_2b may include a display module that outputs a display image and a reflector that reflects the outputted display image to provide it to the user's eyes, thereby providing the user with a virtual reality or augmented reality screen.

The smart watch 10_2c may include a biometric sensor as an input device, and may provide biometric information recognized through the biometric sensor to the user through a display module.

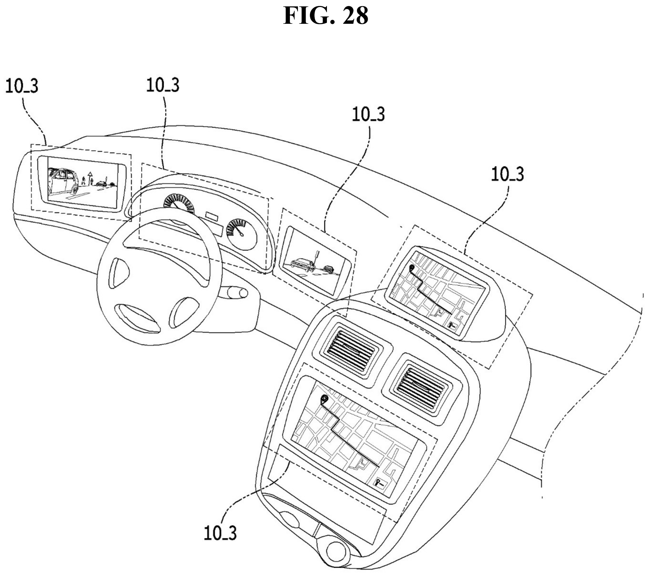

FIG. 28 illustrates a case in which an electronic device including a display module is applied to a vehicle. For example, an electronic device 10_3 may be applied to a dashboard or center fascia of a vehicle, or to a center information display (CID) placed in the dashboard of the vehicle or a room mirror display that replaces a side mirror.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

In concluding the detailed description, those skilled in the art will appreciate that many variations and modifications can be made to the above example embodiments without substantially departing from the principles of the inventive concepts of the present disclosure. Therefore, the above example embodiments of the present disclosure should be considered in a generic and descriptive sense only and not for purposes of limitation.

## Claims

1. A display device (100) comprising:
a substrate (SUB);
a first bending adjacent area (BAA1) between a display area (DA) of the substrate (SUB) and a bending area (BD) of the substrate (SUB);
a first signal transmission line (STL1) overlapping a first wiring area (GDA) of the first bending adjacent area (BAA1) and being adjacent to a first edge (EG1) of the substrate (SUB);
a second signal transmission line (STL2) overlapping a second wiring area (TPA) of the first bending adjacent area (BAA1);
a third signal transmission line (STL3) overlapping a third wiring area (DTA) of the first bending adjacent area (BAA1) and being adjacent to a second edge (EG2) of the substrate (SUB);
the first wiring area (GDA) of the first bending adjacent area (BAA1) including a first contact hole (CT1), through which first interlayer lines (IL1, IL2) of the first signal transmission line (STL1) are interconnected;
the second wiring area (TPA) of the first bending adjacent area (BAA1) including a second contact hole (CT2), through which second interlayer lines (IL1, IL2) of the second signal transmission line (STL2) are interconnected;
the third wiring area (DTA) of the first bending adjacent area (BAA1) including a third contact hole (CT3), through which third interlayer lines (IL1, IL2) of the third signal transmission line (STL3) are interconnected; and
an insulating layer (TILD) overlapping the first signal transmission line (STL1), the second signal transmission line (STL2), the third signal transmission line (STL3), and the second contact hole (CT2) in the first bending adjacent area (BAA1),
wherein in the first bending adjacent area (BAA1), the insulating layer (TILD) is positioned such that at least a part of the first edge (EG1) and at least a part of the second edge (EG2) of the substrate (SUB) remain exposed.

2. The display device (100) of claim 1, wherein
the first wiring area (GDA) of the first bending adjacent area (BAA1) is adjacent to the first edge (EG1) of the substrate (SUB),
the third wiring area (DTA) of the first bending adjacent area (BAA1) is adjacent to the second edge (EG2) of the substrate (SUB), and
the second wiring area (TPA) of the first bending adjacent area (BAA1) is between the first wiring area (GDA) of the first bending adjacent area (BAA1) and the third wiring area (DTA) of the first bending adjacent area (BAA1).

3. The display device (100) of claim 1 or claim 2, wherein the insulating layer (TILD) is positioned such that a portion of the first edge (EG1) of the substrate (SUB) that is adjacent to the first contact hole (CT1) remains exposed.

4. The display device (100) of claim 3, wherein the insulating layer (TILD) is positioned such that a portion of the first edge (EG1) of the substrate (SUB) that faces the first contact hole (CT1) remains exposed, optionally wherein:
in the first bending adjacent area (BAA1),
the insulating layer (TILD) comprises a first extension portion (EX1) overlapping the second contact hole (CT2), and
the insulating layer (TILD) has a substantially linear edge between the first edge (EG1) of the substrate (SUB) and the first extension portion (EX1) of the insulating layer (TILD).

5. The display device (100) of claim 1, wherein a portion of the second edge (EG2) of the substrate (SUB) that is adjacent to the third contact hole (CT3) does not overlap the insulating layer (TILD).

6. The display device (100) of claim 5, wherein the insulating layer (TILD) is positioned such that a portion of the second edge (EG2) of the substrate (SUB) that faces the third contact hole (CT3) remains exposed, optionally wherein:
in the first bending adjacent area (BAA1),
the insulating layer (TILD) comprises a first extension portion (EX1) overlapping the second contact hole (CT2), and
in the first bending adjacent area (BAA1), the insulating layer (TILD) has a substantially linear edge between the second edge (EG2) of the substrate (SUB) and the first extension portion (EX1) of the insulating layer (TILD).

7. The display device (100) of claim 1 or claim 2, wherein
the insulating layer (TILD) is positioned such that a portion of the first edge (EG1) of the substrate (SUB) that faces the first contact hole (CT1) remains exposed,
the insulating layer (TILD) is positioned such that a portion of the second edge (EG2) of the substrate (SUB) that faces the third contact hole (CT3) remains exposed, and
in the first bending adjacent area (BAA1), the insulating layer (TILD) has a substantially linear edge between the first edge (EG1) of the substrate (SUB) and the second edge (EG2) of the substrate (SUB).

8. The display device (100) of any one of claims 1 to 7, further comprising:
a second bending adjacent area (BAA2) between the bending area (BD) of the substrate (SUB) and one edge (EE) of the substrate (SUB);
a first wiring area (GDA) of the second bending adjacent area (BAA2) including a fourth contact hole (CT4), through which the first interlayer lines (IL1, IL2) of the first signal transmission line (STL1) are interconnected;
a second wiring area (TPA) of the second bending adjacent area (BAA2) including a fifth contact hole (CT5), through which the second interlayer lines (IL1, IL2) of the second signal transmission line (STL2) are interconnected; and
a third wiring area (DTA) of the second bending adjacent area (BAA2) including a sixth contact hole (CT6), through which the third interlayer lines (IL1, IL2) of the third signal transmission line (STL3) are interconnected,
wherein in the second bending adjacent area (BAA2), the insulating layer (TILD) further overlaps the first signal transmission line (STL1), the second signal transmission line (STL2), the third signal transmission line (STL3), and the fifth contact hole (CT5), and
in the second bending adjacent area (BAA2), the insulating layer (TILD) is configured such that at least a part of the first edge (EG1) and at least a part of the second edge (EG2) of the substrate (SUB) remain exposed.

9. The display device (100) of claim 8, wherein the insulating layer (TILD) is positioned such that a portion of the first edge (EG1) of the substrate (SUB) that is adjacent to the fourth contact hole (CT4) remains exposed.

10. The display device (100) of claim 9, wherein the insulating layer (TILD) is positioned such that a portion of the first edge (EG1) of the substrate (SUB) that faces the fourth contact hole (CT4) remains exposed, optionally wherein:
in the second bending adjacent area (BAA2),
the insulating layer (TILD) comprises a second extension portion (EX3) overlapping the fifth contact hole (CT5), and
the insulating layer (TILD) has a substantially linear edge between the first edge (EG1) of the substrate (SUB) and the second extension portion (EX3) of the insulating layer (TILD).

11. The display device (100) of claim 8, wherein the insulating layer (TILD) is positioned such that a portion of the second edge (EG2) of the substrate (SUB) that is adjacent to the sixth contact hole (CT6) remains exposed.

12. The display device (100) of claim 11, wherein the insulating layer (TILD) is positioned such that a portion of the second edge (EG2) of the substrate (SUB) that faces the sixth contact hole (CT6) remains exposed, optionally wherein:
in the second bending adjacent area (BAA2),
the insulating layer (TILD) comprises a second extension portion (EX3) overlapping the fifth contact hole (CT5), and
in the second bending adjacent area (BAA2), the insulating layer (TILD) has a substantially linear edge between the second edge (EG2) of the substrate (SUB) and the second extension portion (EX3) of the insulating layer (TILD).

13. The display device (100) of claim 8, wherein
the insulating layer (TILD) is positioned such that a portion of the first edge (EG1) of the substrate (SUB) that faces the fourth contact hole (CT4) remains exposed,
the insulating layer (TILD) is positioned such that a portion of the second edge (EG2) of the substrate (SUB) that faces the sixth contact hole (CT6) remains exposed, and
in the second bending adjacent area (BAA2), the insulating layer (TILD) has a substantially linear edge between the first edge (EG1) of the substrate (SUB) and the second edge (EG2) of the substrate (SUB).

14. An electronic device (50) comprising:
a display device (100) including a screen,
wherein the display device (100) comprises
a substrate (SUB),
a first bending adjacent area (BAA1) between a display area (DA) of the substrate (SUB) and a bending area (BD) of the substrate (SUB),
a first signal transmission line (STL1) overlapping a first wiring area (GDA) of the first bending adjacent area (BAA1) and being adjacent to a first edge (EG1) of the substrate (SUB),
a second signal transmission line (STL2) overlapping a second wiring area (TPA) of the first bending adjacent area (BAA1),
a third signal transmission line (STL3) overlapping a third wiring area (DTA) of the first bending adjacent area (BAA1) and being adjacent to a second edge (EG2) of the substrate (SUB),
the first wiring area (GDA) of the first bending adjacent area (BAA1) including a first contact hole (CT1), through which first interlayer lines (IL1, IL2) of the first signal transmission line (STL1) are interconnected,
the second wiring area (TPA) of the first bending adjacent area (BAA1) including a second contact hole (CT2), through which second interlayer lines (IL1, IL2) of the second signal transmission line (STL2) are interconnected,
the third wiring area (DTA) of the first bending adjacent area (BAA1) including a third contact hole (CT3), through which third interlayer lines (IL1, IL2) of the third signal transmission line (STL3) are interconnected, and
an insulating layer (TILD) overlapping the first signal transmission line (STL1), the second signal transmission line (STL2), the third signal transmission line (STL3), and the second contact hole (CT2) in the first bending adjacent area (BAA1),
wherein in the first bending adjacent area (BAA1), the insulating layer (TILD) is configured such that at least a part of the first edge (EG1) and at least a part of the second edge (EG2) of the substrate (SUB) remain exposed.

15. The electronic device (50) of claim 14, wherein:
(i) the first wiring area (GDA) is adjacent to the first edge (EG1) of the substrate (SUB),
the third wiring area (DTA) is adjacent to the second edge (EG2) of the substrate (SUB),
the second wiring area (TPA) is between the first wiring area (GDA) and the third wiring area (DTA), and
the insulating layer (TILD) is configured such that a portion of the first edge (EG1) of the substrate (SUB) that faces the first contact hole (CT1) remain exposed; and/or
(ii) the electronic device (50) is a wearable device, the wearable device being one of a head mounted display (10_2b), smart glasses (10_2a) or a smart watch (10 2c).
